# EUROPEAN PATENT APPLICATION

(11) **EP 4 697 915 A1**
(43) Date of publication of application: **18.02.2026**
(21) Application number: 25191466.9
(22) Date of filing: 24.07.2025
(51) Int. Cl.: H10K 59/80, H10K 59/126, H10K 59/35, G09G 3/3208, H10K 102/00

(54) **DISPLAY DEVICE AND ELECTRONIC DEVICE, AND METHOD OF DRIVING DISPLAY DEVICE**

(30) Priority: 16.08.2024 KR 20240109592
(71) Applicant: Samsung Display Co., Ltd., Yongin-si, Gyeonggi-do 17113 (KR)
(72) Inventor: KIM, Hyo Min, 17113 Giheung-gu, Yongin-si, Gyeonggi-do (KR); YOO, Gi Na, 17113 Giheung-gu, Yongin-si, Gyeonggi-do (KR); LEE, Seung Hoon, 17113 Giheung-gu, Yongin-si, Gyeonggi-do (KR); HONG, Sang Min, 17113 Giheung-gu, Yongin-si, Gyeonggi-do (KR)
(74) Representative: Dr. Weitzel & Partner

(57) **Abstract**

A display device includes a first pixel and a second pixel disposed in a first unit area among unit areas of a display area, each of the first pixel and the second pixel comprises a first subpixel and a second subpixel, and the first pixel and the second pixel share a third subpixel, a first light blocking layer disposed on a light emitting element layer which comprises light emitting elements of subpixels disposed in each of the unit areas, the first light blocking layer surrounds emission areas of the subpixels, and a second light blocking layer disposed on the first light blocking layer, the second light blocking layer surrounds the emission areas of the first subpixel and the second subpixel of the second pixel in the first unit area, wherein the first pixel and the second pixel are driven in different periods.

## Description

### BACKGROUND

### 1. Technical Field

Embodiments of the invention relate to a display device, an electronic device, and a method of driving display device.

### 2. Description of the Related Art

As the information society develops, demands for display devices for displaying images are increasing in various forms. Accordingly, various types of display devices including light emitting display devices are being developed. A light emitting display device includes pixels, each including a light emitting element.

### SUMMARY

Aspects of the invention provide a display device and an electronic device which can change a viewing angle according to an emission mode, and a method of driving the display device.

However, aspects of the invention are not restricted to the one set forth herein. The above and other aspects of the invention will become more apparent to one of ordinary skill in the art to which the invention pertains by referencing the detailed description of the invention given below.

The invention is defined by the independent claims. Preferred embodiments are described by the dependent claims. According to the invention, a display device comprises a first pixel and a second pixel disposed in a first unit area among unit areas of a display area, each of the first pixel and the second pixel comprises a first subpixel and a second subpixel, and the first pixel and the second pixel share a third subpixel, a first light blocking layer disposed on a light emitting element layer which comprises light emitting elements of subpixels disposed in each of the unit areas, the first light blocking layer surrounds emission areas of the subpixels, and a second light blocking layer disposed on the first light blocking layer, the second light blocking layer surrounds the emission areas of the first subpixel and the second subpixel of the second pixel in the first unit area, wherein the first pixel and the second pixel are driven in different periods. In other words, a display device may include a first pixel and a second pixel disposed in a first unit area of a display area including unit areas, each of the first pixel and the second pixel including a first subpixel and a second subpixel, and the first pixel and the second pixel sharing a third subpixel, a first light blocking layer disposed on a light emitting element layer which includes light emitting elements of subpixels disposed in each of the unit areas and surrounding emission areas in which the light emitting elements are disposed, and a second light blocking layer disposed on the first light blocking layer and surrounding emission areas of the first subpixel and the second subpixel of the second pixel in the first unit area. The first pixel and the second pixel are driven in different periods.

In an embodiment, the first unit area may include first emission areas in which first light emitting elements of the first subpixels are disposed, second emission areas in which second light emitting elements of the second subpixels are disposed, and a third emission area in which a third light emitting element of the third subpixel is disposed. A size of the third emission area may be greater than a size of each of the first emission areas and the second emission areas.

In an embodiment, the first light emitting elements may be red light emitting elements which emit red light, the second light emitting elements may be green light emitting elements which emit green light, and the third light emitting element may be a blue light emitting element which emits blue light.

In an embodiment, the first emission areas and the second emission areas may be disposed adjacent to the third emission area in a first direction.

In an embodiment, the third emission area may have short sides extending in the first direction and long sides extending in a second direction.

In an embodiment, the first emission areas and the second emission areas may be alternately arranged in the second direction.

In an embodiment, the display device may further include a first pixel and a second pixel disposed in a second unit area among the unit areas, each of the first pixel and the second pixel in the second unit area includes a first subpixel and a second subpixel, and the first pixel and the second pixel in the second unit area share a third subpixel. The second light blocking layer in the first unit area and the second light blocking layer in the second unit area may have different shapes.

In an embodiment, the second light blocking layer may surround the emission areas of the first subpixel and the second subpixel of the second pixel and the emission area of the third subpixel in the second unit area in a plan view.

In an embodiment, the second light blocking layer may surround only the emission areas of the first subpixel and the second subpixel of the second pixel among the emission areas of the first unit area in a plan view.

In an embodiment, the unit areas may include a plurality of first unit areas of a same structure as the first unit area and a plurality of second unit areas of a same structure as the second unit area, and the plurality of first unit areas and the plurality of second unit areas may be alternately arranged in a first direction.

In an embodiment, the plurality of first unit areas and the plurality of second unit areas may be alternately arranged in a second direction intersecting the first direction.

In an embodiment, the first subpixel and the second subpixel of the first pixel and the first subpixel and the second subpixel of the second pixel may be sequentially disposed in the first unit area in one direction, and the first subpixel and the second subpixel of the second pixel and the first subpixel and the second subpixel of the first pixel may be sequentially disposed in the second unit area in the one direction.

In an embodiment, the first light blocking layer may surround emission areas of all subpixels disposed in each of the unit areas and may include openings which expose the light emitting elements of the all subpixels in a plan view, and the second light blocking layer may surround emission areas of some of the subpixels disposed in each of the unit areas and may include openings which expose the light emitting elements of the some of the subpixels in a plan view.

In an embodiment, the second light blocking layer may be disposed closer to the light emitting elements of the some of the subpixels than the first light blocking layer in a plan view.

In an embodiment, first pixels and second pixels disposed in the unit areas may be driven in different ways in response to a first emission mode, a second emission mode, and a third emission mode.

In an embodiment, the first pixels may be driven in each frame period in response to the first emission mode, the second pixels may be driven in each frame period in response to the second emission mode, and the first pixels and the second pixels may be alternately driven in each frame period in response to the third emission mode.

In an embodiment, the display device may further include a display driver supplying data signals of the each frame period to the first pixels and the second pixels. The display driver may supply data signals corresponding to a resolution of the first pixels or the second pixels to the first pixels or the second pixels in response to the first emission mode and the second emission mode and supplies data signals corresponding to a resolution of the first pixels and the second pixels to the first pixels and the second pixels in response to the third emission mode.

According to an embodiment of the invention, a method of driving a display device includes a first pixel and a second pixel disposed in each of unit areas of a display area and sharing one subpixel, the method including, displaying an image of each frame by driving the first pixels disposed in the unit areas in response to a first emission mode, displaying an image of each frame by driving the second pixels disposed in at least some of the unit areas in response to a second emission mode, and displaying an image of each frame by alternately driving the first pixels and the second pixels disposed in the unit areas in response to a third emission mode.

In an embodiment, data signals corresponding to a resolution of the first pixels or the second pixels may be supplied to the first pixels or the second pixels in response to the first emission mode and the second emission mode, and data signals corresponding to a resolution of the first pixels and the second pixels may be supplied to the first pixels and the second pixels in response to the third emission mode.

In an embodiment, in response to the third emission mode, one frame period may be divided into a first sub-frame period and a second sub-frame period, the first pixels may be driven during the first sub-frame period, and the second pixels may be driven during the second sub-frame period.

According to an embodiment of the invention, an electronic device includes a first pixel and a second pixel disposed in a first unit area among unit areas of a display area, each of the first pixel and the second pixel comprises a first subpixel and a second subpixel, and the first pixel and the second pixel share a third subpixel, a first light blocking layer disposed on a light emitting element layer which comprises light emitting elements of subpixels disposed in each of the unit areas, the first light blocking layer surrounds emission areas of the subpixels, and a second light blocking layer disposed on the first light blocking layer, the second light blocking layer surrounds the emission areas of the first subpixel and the second subpixel of the second pixel in the first unit area wherein the first pixel and the second pixel are driven in different periods. In other words, an electronic device may include a display device. The display device may include a first pixel and a second pixel disposed in a first unit area of a display area including unit areas, each of the first pixel and the second pixel including a first subpixel and a second subpixel, and the first pixel and the second pixel sharing a third subpixel, a first light blocking layer disposed on a light emitting element layer which includes light emitting elements of subpixels disposed in each of the unit areas and surrounding emission areas in which the light emitting elements are disposed, and a second light blocking layer disposed on the first light blocking layer and surrounding emission areas of the first subpixel and the second subpixel of the second pixel in the first unit area. The first pixel and the second pixel are driven in different periods.

A display device and an electronic device according to embodiments may include a first pixel and a second pixel disposed in each unit area and sharing at least one subpixel. In some embodiments, the first pixel and the second pixel may have different structures in relation to a light blocking layer, and side luminance ratios of the first pixel and the second pixel may be different. According to a display device, an electronic device and a method of driving the display device according to embodiments, a viewing angle of the display device and the electronic device may be appropriately or readily changed by selectively driving the first pixel and the second pixel according to each emission mode. The deterioration of the subpixel shared by the first pixel and the second pixel may be alleviated, and the lifespan of the display device and an electronic device may be improved.

In some embodiments, an image with a wide viewing angle may be displayed by driving the first pixel disposed in each unit area in response to a first emission mode, and an image with limited side visibility may be displayed by driving the second pixel disposed in each unit area in response to a second emission mode. A high-resolution image may be displayed by alternately driving the first pixel and the second pixel disposed in each unit area in response to a third emission mode.

However, effects according to the embodiments of the invention are not limited to those exemplified above and various other effects are incorporated herein.

### BRIEF DESCRIPTION OF THE DRAWINGS

These and/or other aspects will become apparent and more readily appreciated from the following description of the embodiments, taken in conjunction with the accompanying drawings in which:
FIG. 1 is a perspective view of an electronic device according to an embodiment;
FIG. 2 is a perspective view of a display device included in the electronic device according to the embodiment;
FIG. 3 is a schematic cross-sectional view of the display device of FIG. 2 as viewed from the side;
FIG. 4 is a plan view of a display area of a display device according to an embodiment;
FIG. 5 is a plan view of a display area of a display device according to an embodiment;
FIG. 6 is a plan view of a display area of a display device according to an embodiment;
FIG. 7 is a plan view of a display area of a display device according to an embodiment;
FIG. 8 is a schematic cross-sectional view of a display device according to an embodiment;
FIG. 9 is a schematic cross-sectional view of the display device according to an embodiment
FIG. 10 is a schematic cross-sectional view of the display device according to an embodiment;
FIG. 11 is a schematic cross-sectional view of the display device according to an embodiment;
FIGS. 12 through 20 are schematic diagrams illustrating a method of driving a display device according to an embodiment;
FIGS. 21 and 22 are schematic diagrams illustrating a method of driving a display device according to an embodiment; and
FIGS. 23 and 24 are schematic diagrams illustrating a method of driving a display device according to an embodiment.

### DETAILED DESCRIPTION OF THE EMBODIMENTS

The invention will now be described more fully hereinafter with reference to the accompanying drawings, in which embodiments of the invention are shown. This invention may, however, be embodied in different forms and should not be construed as limited to the embodiments set forth herein. Rather, these embodiments are provided so that this invention will be more thorough and complete, and will fully convey the scope of the invention to those skilled in the art.

When an element, such as a layer, is referred to as being "on," "connected to," or "coupled to" another element or layer, it may be directly on, connected to, or coupled to the other element or layer or intervening elements or layers may be present. When, however, an element or layer is referred to as being "directly on," "directly connected to," or "directly coupled to" another element or layer, there are no intervening elements or layers present. To this end, the term "connected" may refer to physical, electrical, and/or fluid connection, with or without intervening elements. Also, when an element is referred to as being "in contact" or "contacted" or the like to another element, the element may be in "electrical contact" or in "physical contact" with another element; or in "indirect contact" or in "direct contact" with another element. The same reference numbers indicate the same components throughout the specification.

It will be understood that, although the terms "first," "second," etc. may be used herein to describe various elements, these elements should not be limited by these terms. These terms are only used to distinguish one element from another element. For instance, a first element discussed below could be termed a second element without departing from the teachings of the invention. Similarly, the second element could also be termed the first element.

Features of each of various embodiments of the invention may be partially or entirely combined with each other and may technically variously interwork with each other, and respective embodiments may be implemented independently of each other or may be implemented together in association with each other.

Spatially relative terms, such as "beneath," "below," "under," "lower," "above," "upper," "over," "higher," "side" (e.g., as in "sidewall"), and the like, may be used herein for descriptive purposes, and, thereby, to describe one elements relationship to another element(s) as illustrated in the drawings. Spatially relative terms are intended to encompass different orientations of an apparatus in use, operation, and/or manufacture in addition to the orientation depicted in the drawings. For example, if the apparatus in the drawings is turned over, elements described as "below" or "beneath" other elements or features would then be oriented "above" the other elements or features. Thus, the exemplary term "below" can encompass both an orientation of above and below. Furthermore, the apparatus may be otherwise oriented (e.g., rotated 90 degrees or at other orientations), and, as such, the spatially relative descriptors used herein interpreted accordingly.

"About" or "approximately" as used herein is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" may mean within one or more standard deviations, or within ± 30%, 20%, 10%, 5% of the stated value.

In the specification and the claims, the phrase "at least one of" is intended to include the meaning of "at least one selected from the group of" for the purpose of its meaning and interpretation. For example, "at least one of A and B" may be understood to mean "A, B, or A and B." In the specification and the claims, the term "and/or" is intended to include any combination of the terms "and" and "or" for the purpose of its meaning and interpretation. For example, "A and/or B" may be understood to mean "A, B, or A and B." The terms "and" and "or" may be used in the conjunctive or disjunctive sense and may be understood to be equivalent to "and/or."

Unless otherwise defined or implied herein, all terms (including technical and scientific terms) used have the same meaning as commonly understood by those skilled in the art to which this invention pertains. It will be further understood that terms, such as those defined in commonly used dictionaries, should be interpreted as having a meaning that is consistent with their meaning in the context of the relevant art and should not be interpreted in an ideal or excessively formal sense unless clearly defined in the specification.

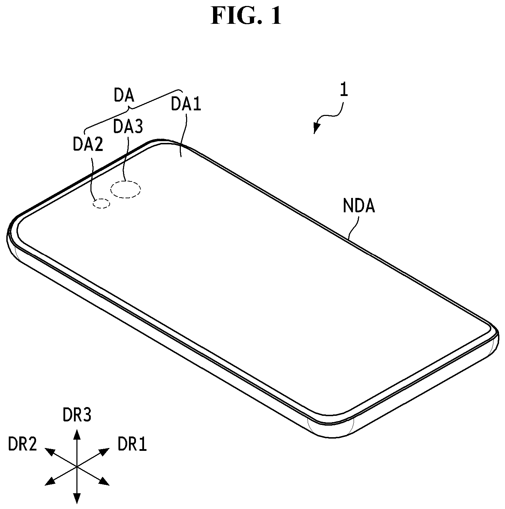

FIG. 1 is a perspective view of an electronic device 1 according to an embodiment.

Referring to FIG. 1, the electronic device 1 may display moving images or still images. The electronic device 1 may be any electronic device that provides a display screen. Examples of the electronic device 1 may include a television, a notebook computer, a monitor, a billboard, an Internet of things (IoT) device, a mobile phone, a smartphone, a tablet personal computer (PC), an electronic watch, a smart watch, a watch phone, a head-mounted display, a mobile communication terminal, an electronic notebook, an electronic book, a portable multimedia player (PMP), a navigation device, a game console, a digital camera and a camcorder, all of which provide a display screen.

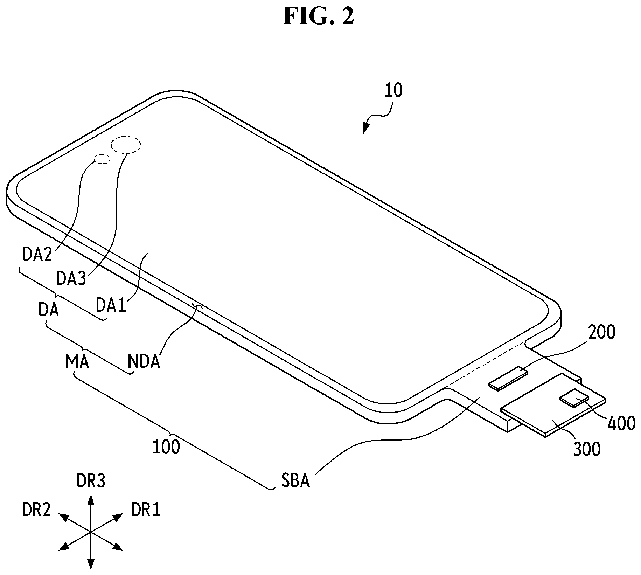

The electronic device 1 may include a display device (e.g., a display device 10 of FIG. 2) that provides a display screen. In an embodiment, the display device may be, but is not limited to, a light emitting display device including a light emitting element such as an inorganic light emitting diode or an organic light emitting diode. For example, the specification discloses a light emitting display device including an organic light emitting diode as a display device according to an embodiment. However, devices or fields to which the embodiments can be applied are not limited thereto. For example, the embodiments can also be applied to other types of display devices or electronic devices including the same.

The shape of the electronic device 1 may be variously modified. For example, the electronic device 1 may have various shapes in a plan view such as a horizontally long rectangle, a vertically long rectangle, a square, a substantially quadrangular shape with rounded corners, other polygons, and a circle. In an embodiment, the shape of a display area DA of the electronic device 1 may be similar to the overall shape of the electronic device 1, but embodiments are not limited thereto. In FIG. 1, the electronic device 1 is shaped like a rectangle that is longer in a second direction DR2 than in a first direction DR1.

The electronic device 1 may include a display area DA and a non-display area NDA. The display area DA may be an area where an image can be displayed, and the non-display area NDA may be an area where no image is displayed. The display area DA may also be referred to as an active area, and the non-display area NDA may also be referred to as an inactive area. The display area DA may generally occupy a center of the electronic device 1.

The display area DA may include a first display area DA1, a second display area DA2, and a third display area DA3. The second display area DA2 and the third display area DA3 may be areas where components for adding various functions to the electronic device 1 are disposed. The second display area DA2 and the third display area DA3 may be component areas. Although FIG. 1 discloses an embodiment in which the electronic device 1 includes two component areas, the number or position of component areas is not limited thereto. The first display area DA1 may be an area where no component is disposed in the display area DA.

FIG. 2 is a perspective view of a display device 10 included in the electronic device 1 according to the embodiment.

Referring to FIGS. 1 and 2, the electronic device 1 according to an embodiment may include a display device 10. The display device 10 may provide a screen of the electronic device 1. The display device 10 may have a planar shape similar to the shape of the electronic device 1 or the screen of the electronic device 1. For example, the display device 10 may be shaped like a rectangle having short sides in the first direction DR1 and long sides in the second direction DR2. Each corner where a short side extending in the first direction DR1 meets a long side extending in the second direction DR2 may be rounded. However, embodiments are not limited thereto, and each corner may be right-angled. The planar shape of the display device 10 is not limited to a quadrangular shape but may be other polygonal shapes, a circular shape, an oval shape, or other shapes.

The display device 10 may include a display panel 100, a display driver 200, and a circuit board 300. In case that the display device 10 provides a touch input function, the display device 10 may further include a touch driver 400.

The display panel 100 may have a main area MA and a sub-area SBA.

The main area MA may include a display area DA including pixels that display an image and a non-display area NDA disposed adjacent to the display area DA. The display area DA may be disposed in a center of the main area MA, and the non-display area NDA may surround the display area DA.

The display area DA may include a first display area DA1, a second display area DA2, and a third display area DA3. The display area DA may include emission areas of the pixels and may emit light from the emission areas.

The display panel 100 may include circuit elements constituting pixel circuits of the pixels, light emitting elements electrically connected to the circuit elements, and a pixel defining layer surrounding the emission areas of the pixels in a plan view. A light emitting element of each of the pixels may be disposed in an emission area of the pixel. In an embodiment, the light emitting element may be, but is not limited to, one of an organic light emitting diode including an organic light emitting layer, a quantum dot light emitting diode including a quantum dot light emitting layer, an inorganic light emitting diode including an inorganic semiconductor, and an ultrasmall light emitting diode such as a micro-light emitting diode or a nano-light emitting diode.

The non-display area NDA may be an area outside the display area DA. For example, the non-display area NDA may be an edge area of the main area MA. In an embodiment, the non-display area NDA may include a gate driver (not illustrated) which supplies gate signals to gate lines and fan-out lines (not illustrated) which connect the display driver 200 and the display area DA.

The sub-area SBA may be an area extending from a side of the main area MA. The sub-area SBA may have flexible characteristics so that it can be bent, folded, rolled, etc. In an embodiment, in case that the sub-area SBA is bent (or folded), the sub-area SBA may overlap the main area MA in a thickness direction (e.g., a third direction DR3). For example, in case that the sub-area SBA of the display device 10 is bent, at least a portion of the sub-area SBA including an area where the display driver 200 is disposed and an area where a pad unit connected to the circuit board 300 is disposed may be placed below the main area MA.

The sub-area SBA may include the display driver 200 and the pad unit electrically connected to the circuit board 300. In an embodiment, the sub-area SBA may be omitted, and the display driver 200 and the pad unit may be disposed in the non-display area NDA of the main area MA. In an embodiment, the display driver 200 may be disposed on the circuit board 300 connected to the display panel 100 and may be electrically connected to the display panel 100 through the pad unit.

The display driver 200 may output driving signals and driving voltages for driving the display panel 100. For example, the display driver 200 may supply data voltages to data lines, supply driving voltages (e.g., a first pixel voltage (or an anode voltage) and a second pixel voltage (or a cathode voltage)) to power lines, and supply gate control signals to the gate driver. In an embodiment, the display driver 200 may be formed as an integrated circuit and mounted on the display panel 100 by a chip on glass (COG) method, a chip on plastic (COP) method, or an ultrasonic bonding method.

The circuit board 300 may be attached onto the pad unit of the display panel 100 using an anisotropic conductive film. Lead lines of the circuit board 300 may be electrically connected to the pad unit of the display panel 100. In an embodiment, the circuit board 300 may be a flexible printed circuit board, a printed circuit board, or a flexible film such as a chip on film.

The touch driver 400 may be mounted on the circuit board 300. The touch driver 400 may be connected to a touch sensing layer of the display panel 100. The touch driver 400 may supply a touch driving signal to each of touch electrodes of the touch sensing layer and sense a change in capacitance formed between the touch electrodes. In an embodiment, the touch driving signal may be a pulse signal having a frequency. The touch driver 400 may detect whether a touch input has been made and coordinates of the touch input based on a change in capacitance between the touch electrodes. In an embodiment, the touch driver 400 may be formed as an integrated circuit.

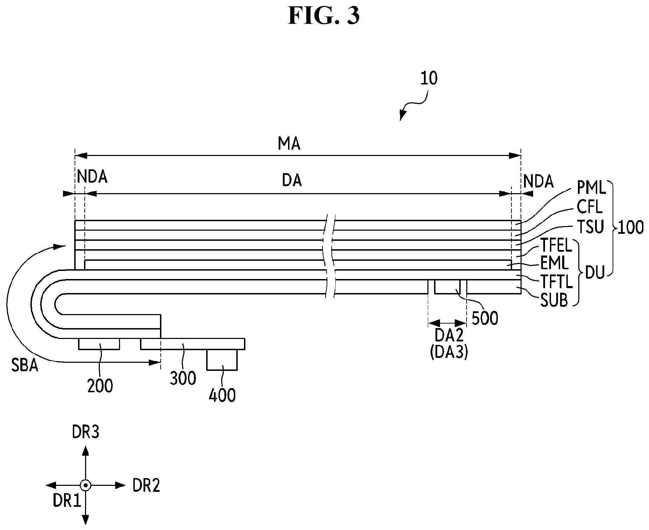

FIG. 3 is a schematic cross-sectional view of the display device 10 of FIG. 2 as viewed from the side. FIG. 3 schematically illustrates a state where the sub-area SBA of the display panel 100 in the display device 10 of FIG. 2 is bent.

Referring to FIG. 3, the display panel 100 may include a display layer DU, a touch sensing layer TSU, a color filter layer CFL, and a light blocking member layer PML. In FIG. 3, the color filter layer CFL and the light blocking member layer PML are illustrated separately, but embodiments are not limited thereto. In another embodiment, the color filter layer CFL and the light blocking member layer PML may components included in one light control layer having a multilayer structure, elements of the color filter layer CFL may be disposed in a lower layer of the light control layer, and elements of the light blocking member layer PML may be disposed in an upper layer of the light control layer.

The display layer DU may include a substrate SUB, a thin-film transistor layer TFTL, a light emitting element layer EML, and an encapsulation layer TFEL.

The substrate SUB may be a base substrate or a base member. The substrate SUB may be, but is not limited to, a flexible substrate that can be bent, folded, rolled, etc. In an embodiment, the substrate SUB may include polymer resin including polyimide (PI). In another embodiment, the substrate SUB may include a glass material or a metal material.

The thin-film transistor layer TFTL may be disposed on the substrate SUB. The thin-film transistor layer TFTL may include circuit elements, for example, thin-film transistors and capacitors constituting pixel circuits of pixels. The thin-film transistor layer TFTL may further include lines. For example, the thin-film transistor layer TFTL may further include gate lines, data lines, power lines, gate control lines, fan-out lines connecting the display driver 200 and the data lines, and lead lines connecting the display driver 200 and the pad unit. Each of the thin-film transistors may include a semiconductor region, a source electrode, a drain electrode, and a gate electrode. In an embodiment, in case that the display panel 100 includes a gate driver disposed in the non-display area NDA, the thin-film transistor layer TFTL may further include circuit elements constituting the gate driver.

The thin-film transistor layer TFTL may be disposed in the display area DA, the non-display area NDA, and the sub-area SBA. The circuit elements constituting the pixel circuits of the pixels and the gate lines, the data lines, and the power lines electrically connected to the pixels may be disposed in the display area DA of the thin-film transistor layer TFTL. The gate lines, the data lines, and the power lines may extend to the non-display area NDA of the thin-film transistor layer TFTL and may be electrically connected to the gate driver, the display driver 200, or the pad unit. The gate control lines and the fan-out lines may be disposed in the non-display area NDA of the thin-film transistor layer TFTL. The lead lines may be disposed in the sub-area SBA of the thin-film transistor layer TFTL.

The light emitting element layer EML may be disposed on the thin-film transistor layer TFTL. The light emitting element layer EML may include a pixel defining layer defining emission areas (or light emitting element areas) of the pixels and light emitting elements disposed in the emission areas.

In an embodiment, each pixel may include multiple subpixels and may include multiple pixel circuits and multiple light emitting elements which constitute the subpixels. An emission area of each of the subpixels may be disposed in a pixel area or a subpixel area of the display area DA. For example, a subpixel area in which each subpixel is disposed may include a pixel circuit area in which circuit elements constituting a pixel circuit of the subpixel are disposed and an emission area in which a light emitting element of the subpixel is disposed. In an embodiment, the pixel circuit area and the emission area of each subpixel may overlap each other in the third direction DR3.

A light emitting element may include a first electrode and a second electrode facing each other and a light emitting layer interposed between the first electrode and the second electrode. In an embodiment, the first electrode of the light emitting element may be formed as a separate pixel electrode for each subpixel, and the second electrode of the light emitting element may be formed as a common electrode shared by the subpixels. In an embodiment, the light emitting layer may be an organic light emitting layer including an organic material. The light emitting layer may include a hole transporting layer, an organic light emitting layer, and an electron transporting layer. In case that a first pixel voltage (e.g., an anode voltage) is applied to the first electrode of the light emitting element through at least one of the thin-film transistors of each pixel circuit and a second pixel voltage (e.g., a cathode voltage) is applied to the second electrode of the light emitting element through a power line, holes and electrons may recombine in the organic light emitting layer, and thus the light emitting element may emit light. In an embodiment, the light emitting element may be other types of light emitting elements, such as a quantum dot light emitting diode including a quantum dot light emitting layer, an inorganic light emitting diode including an inorganic semiconductor, a micro-light emitting diode, or a nano-light emitting diode.

The encapsulation layer TFEL may cover upper and side surfaces of the light emitting element layer EML and may protect the light emitting element layer EML. In an embodiment, the encapsulation layer TFEL may include at least one inorganic layer and at least one organic layer to encapsulate the light emitting element layer EML. For example, the encapsulation layer TFEL may include multiple inorganic layers and an organic layer interposed between the inorganic layers.

The touch sensing layer TSU may be disposed on the display layer DU. For example, the touch sensing layer TSU may be disposed or formed on the encapsulation layer TFEL or may be disposed on a separate substrate disposed on the display layer DU.

The touch sensing layer TSU may include touch electrodes for sensing a user's touch input and lines for electrically connecting the touch electrodes and the touch driver 400. In an embodiment, the touch sensing layer TSU may sense a user's touch in a mutual capacitance manner or a self-capacitance manner, and the touch electrodes may have a shape for forming a mutual capacitance or self- capacitance touch sensor.

The touch electrodes of the touch sensing layer TSU may be disposed in a touch sensing area in the display area DA. An area where the touch electrodes are disposed in the display area DA may be the touch sensing area. For example, the touch sensing area may be a whole or a part of the display area DA. The lines electrically connected to the touch electrodes of the touch sensing layer TSU may be disposed in a peripheral area in the non-display area NDA. If the display device 10 does not provide touch input, the display device 10 may not include the touch sensing layer TSU and the touch driver 400.

The color filter layer CFL may be disposed on the touch sensing layer TSU. The color filter layer CFL may include color filters corresponding to the emission areas of the pixels, respectively. Each of the color filters may transmit only light of a specific color or wavelength and block or absorb light of other colors or wavelengths. In an embodiment, the color filter layer CFL may further include a first light blocking layer (or first light blocking patterns constituting the first light blocking layer) surrounding the emission areas of the pixels in a plan view. The first light blocking layer may be formed separately from the color filters using a light blocking material (e.g., a light absorbing material) or may be formed by stacking multiple color filters that selectively transmit light of different wavelengths.

The color filter layer CFL may absorb a portion of light coming from the outside of the display device 10 to reduce reflected light caused by the external light. The color filter layer CFL may prevent color distortion caused by reflection of the external light.

In an embodiment, the color filter layer CFL may be disposed on (e.g., directly disposed on) the touch sensing layer TSU. Accordingly, the display device 10 may not require a separate substrate for the color filter layer CFL and may have a reduced thickness.

The light blocking member layer PML may be disposed on the color filter layer CFL. The light blocking member layer PML may include a second light blocking layer (or second light blocking patterns constituting the second light blocking layer) corresponding to some pixels (or some subpixels) of the display layer DU. For example, the light blocking member layer PML may include a second light blocking layer disposed close to light emitting elements in emissions areas of some pixels and surrounding the light emitting elements in a plan view.

The light blocking member layer PML may limit a viewing angle of an image displayed by the above some pixels. For example, the display device 10 including the light blocking member layer PML may control visibility at a specific viewing angle and provide a user with a side viewing angle limitation mode such as a privacy mode.

In some embodiments, the display device 10 may further include an optical device 500 disposed in a component area (e.g., the second display area DA2 or the third display area DA3 of FIGS. 1 and 2). The optical device 500 may emit or receive light in an infrared, ultraviolet, or visible light band. For example, the optical device 500 may be an optical sensor that senses light incident on the display device 10, such as a proximity sensor, an illuminance sensor, a camera sensor, a fingerprint sensor or an image sensor.

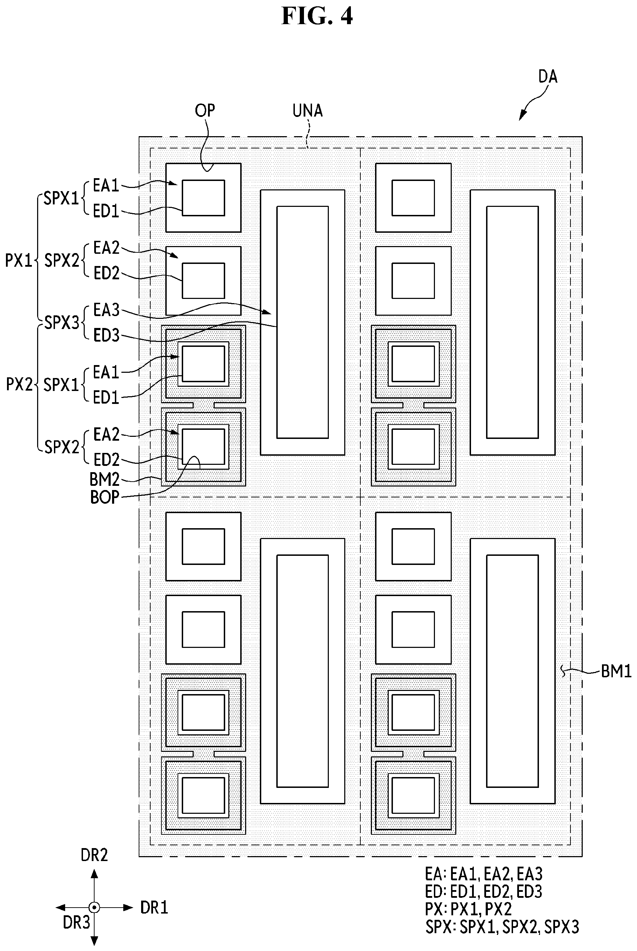

FIG. 4 is a plan view of a display area DA of a display device 10 according to an embodiment. For example, FIG. 4 schematically illustrates light emitting elements ED disposed in the display area DA of the display device 10 according to an embodiment and a first light blocking layer BM1 and a second light blocking layer BM2 disposed around the light emitting elements ED.

Referring to FIG. 4, the display area DA may include multiple unit areas UNA. In an embodiment, the unit areas UNA may be arranged in a matrix form along the first direction DR1 and the second direction DR2. However, the arrangement form or direction of the unit areas UNA is not limited thereto.

A pair of a first pixel PX1 and a second pixel PX2 may be disposed in each of the unit areas UNA. In an embodiment, the number, type and structure (e.g., arrangement structure) of pixels PX disposed in each of the unit areas UNA may be substantially the same.

Each of the first pixel PX1 and the second pixel PX2 may include multiple subpixels SPX, and the first pixel PX1 and the second pixel PX2 may share at least one subpixel SPX. For example, each of the first pixel PX1 and the second pixel PX2 may include a first subpixel SPX1 emitting light of a first color, a second subpixel SPX2 emitting light of a second color, and a third subpixel SPX3 emitting light of a third color, and the first pixel PX1 and the second pixel PX2 may share one third subpixel SPX3.

The first pixel PX1 and the second pixel PX2 may be driven during different periods. For example, the first pixel PX1 and the second pixel PX2 may be driven in different emission modes or may be driven alternately or sequentially in a specific emission mode.

In an embodiment, the first subpixels SPX1 and the second subpixels SPX2 disposed in each unit area UNA may be alternately arranged in the second direction DR2. For example, in each unit area UNA, the first subpixel SPX1 of the first pixel PX1, the second subpixel SPX2 of the first pixel PX1, the first subpixel SPX1 of the second pixel PX2, and the second subpixel SPX2 of the second pixel PX2 may be arranged sequentially in the second direction DR2, and first emission areas EA1 and second emission areas EA2 disposed in each unit area UNA may be alternately arranged in the second direction DR2.

The third subpixel SPX3 shared by the first pixel PX1 and the second pixel PX2 may neighbor at least one of the first subpixels SPX1 and the second subpixels SPX2 of the first pixel PX1 and the second pixel PX2 in the first direction DR1. For example, in each unit area UNA, a third emission area EA3 of the third subpixel SPX3 may be disposed adjacent to the first emission areas EA1 and the second emission areas EA2 of the first subpixels SPX1 and the second subpixels SPX2 in the first direction DR1. However, the arrangement structure or position of the subpixels SPX may vary according to embodiments.

In an embodiment, the first color, the second color, and the third color may be red, green, and blue. For example, the first pixel PX1 and the second pixel PX2 may each individually include one red subpixel and one green subpixel, and the first pixel PX1 and the second pixel PX2 may share one blue subpixel. However, embodiments are not limited thereto, and the types of subpixels SPX included in the first pixel PX1 and the second pixel PX2 and the colors of light emitted from the subpixels SPX may vary according to embodiments. For example, the first pixel PX1 and the second pixel PX2 may each individually include a blue subpixel, and the first pixel PX1 and the second pixel PX2 may share a red subpixel or a green subpixel.

Each subpixel SPX may include a light emitting element ED disposed in an emission area EA. For example, the first subpixel SPX1 may include a first light emitting element ED1 disposed in the first emission area EA1, the second subpixel SPX2 may include a second light emitting element ED2 disposed in the second emission area EA2, and the third subpixel SPX3 may include a third light emitting element ED3 disposed in the third emission area EA3.

In the description of embodiments, an emission area EA may be a light transmitting area, through which light emitted from a light emitting element ED of a subpixel SPX may pass, in a subpixel area in which the subpixel SPX is disposed. For example, in FIG. 4, in a plan view, an area including a light emitting element area where a light emitting element ED of each subpixel SPX is disposed and not covered by the first light blocking layer BM1 and the second light blocking layer BM2 is shown as an emission area EA of each subpixel SPX. An area other than the emission area EA in each subpixel area may be a non-emission area. Similarly, in each unit area UNA and the display area DA including the unit areas UNA, an area other than the emission areas EA of the subpixels SPX may be a non-emission area. However, a standard for distinguishing the emission areas EA from the non-emission area may be changed. For example, areas where pixel electrodes (e.g., first electrodes of the light emitting elements ED) are exposed by openings of a pixel defining layer that defines light emitting element areas where the light emitting elements ED are disposed may be defined as an emission areas EA.

In other words, a first light blocking layer BM1 may be disposed on a light emitting element layer EML which comprises light emitting elements ED of subpixels SPX disposed in each of the first unit areas UNA1 and are surrounded by emission areas EA. A second light blocking layer BM2 may be disposed on the first light blocking layer BM1, the light blocking layer BM2 may surround the emission areas EA of the first subpixel SPX1 and the second subpixel SPX2 of the second pixel PX2 in the first unit area UNA1.

Each light emitting element ED of FIG. 4 may be an area where the light emitting element ED is disposed or formed based on a pixel electrode included in the light emitting element ED. For example, in FIG. 4, an area where a light emitting layer and a common electrode of a light emitting element ED are disposed on a portion of a pixel electrode of the light emitting element ED, which is exposed by an opening of the pixel defining layer, to form the light emitting element ED may be shown in the form of the light emitting element ED.

In an embodiment, the first light emitting element ED1, the second light emitting element ED2, and the third light emitting element ED3 may emit light of different colors. For example, the first light emitting element ED1, the second light emitting element ED2, and the third light emitting element ED3 may emit light of the first color, light of the second color, and light of the third color, respectively. For example, the first light emitting element ED1 may be a red light emitting element that emits red light, the second light emitting element ED2 may be a green light emitting element that emits green light, and the third light emitting element ED3 may be a blue light emitting element that emits blue light. Accordingly, each pixel PX may emit light of various colors that can be expressed by at least one of light of the first color, light of the second color, and light of the third color. The number, type, and/or ratio of light emitting elements ED included in each pixel PX may vary according to embodiments.

In an embodiment, the pixels PX may include light emitting elements ED generally having a uniform size. For example, a size of the first light emitting element ED1 of the first pixel PX1 and a size of the first light emitting element ED1 of the second pixel PX2 may be substantially the same, and a size of the second light emitting element ED2 of the first pixel PX1 and a size of the second light emitting element ED2 of the second pixel PX2 may be substantially the same. For example, the pixel defining layer may have an opening having a uniform size in a plan view for each subpixel SPX in the first pixel PX1 and the second pixel PX2.

In an embodiment, at least two subpixels SPX among the subpixels SPX constituting each pixel PX may have different light emitting areas. For example, the light emitting area of the third subpixel SPX3 may be larger than the light emitting area of the first subpixel SPX1 and the light emitting area of the second subpixel SPX2 in a plan view. For example, in a plan view, a size of the third emission area EA3 may be greater than a size of each of the first emission area EA1 and the second emission area EA2, and a size of the third light emitting element ED3 may be greater than the size of each of the first light emitting element ED1 and the second light emitting element ED2.

In an embodiment, the third light emitting element ED3 may extend in the second direction DR2. For example, the third light emitting element ED3 and the third emission area EA3 including the third light emitting element ED3 may include short sides extending in the first direction DR1 and long sides extending in the second direction DR2. In an embodiment, a length of the third light emitting element ED3 in the second direction DR2 may be greater than a length of each of the first light emitting element ED1 and the second light emitting element ED2 in the second direction DR2.

FIG. 4 schematically illustrates an embodiment in which the size of the first light emitting element ED1 and the size of the second light emitting element ED2 are the same, and the size of the first emission area EA1 and the size of the second emission area EA2 are the same. However, embodiments are not limited thereto. For example, the sizes of the light emitting elements ED disposed in each pixel PX or each unit area UNA and the sizes of the emission areas EA including the light emitting elements ED may be appropriately adjusted or differentiated according to the light efficiency and lifespan of the light emitting elements ED and the color of the pixel PX.

In an embodiment, a subpixel SPX shared by the first pixel PX1 and the second pixel PX2 may be determined in consideration of the lifespan characteristics of the light emitting elements ED. For example, a subpixel SPX including a light emitting element ED with the shortest lifespan among the first light emitting element ED1, the second light emitting element ED2, and the third light emitting element ED3 may be formed as a subpixel SPX shared by the first pixel PX1 and the second pixel PX2. For example, if the lifespan of the third light emitting element ED3 is the shortest among the first light emitting element ED1, the second light emitting element ED2 and the third light emitting element ED3, the first pixel PX1 and the second pixel PX2 may be formed to share the third light emitting element ED3, and the size of the third light emitting element ED3 may be increased. If the size (e.g., light emitting area) of the third light emitting element ED3 increases, the amount of light emitted from the third light emitting element ED3 for a same driving current may increase. In case that luminance corresponding to each gray level is expressed using the third light emitting element ED3, if the light emitting area of the third light emitting element ED3 increases, a driving current (or current density) flowing to the third light emitting element ED3 may be reduced. Accordingly, the deterioration of the third light emitting element ED3 may be delayed, and the lifespan of the third light emitting element ED3 may be improved. For example, in case that a size of the third subpixel SPX3 is expanded by allowing the first pixel PX1 and the second pixel PX2 to share the third subpixel SPX3, the lifespan of the third subpixel SPX3 may be increased by about 2.5 times. As a result, the lifespan of the display device 10 may be improved.

For example, if the lifespan of a blue light emitting element is the shortest among a red light emitting element, a green light emitting element, and the blue light emitting element, a pair of the first pixel PX1 and the second pixel PX2 may share a blue subpixel including the blue light emitting element. Accordingly, the deterioration of the blue subpixel may be alleviated, and the lifespan of the display device 10 may be increased. In an embodiment, in case that the lifespan of the red light emitting element or the green light emitting element needs to be improved for a purposes or needs, a pair of the first pixel PX1 and the second pixel PX2 may be formed to share a red subpixel or a green subpixel. For example, the third subpixel SPX3 may be a blue subpixel, but embodiments are not limited thereto, and the third subpixel SPX3 may be a red subpixel or a green subpixel.

The color of a screen displayed on the display device 10 or the electronic device 1 may be controlled by adjusting the size of each light emitting element ED and each emission area EA including the light emitting element ED. For example, the sizes of the light emitting elements ED and the emission areas EA including the light emitting elements ED may be appropriately adjusted or differentiated in consideration of at least one of the light efficiency and lifespan of each light emitting element ED and each subpixel SPX including the light emitting element ED and the color of each pixel PX.

The emission areas EA of the subpixels SPX may be surrounded by at least the first light blocking layer BM1 in a plan view. For example, the first emission areas EA1, the second emission areas EA2, and the third emission area EA3 of the first pixel PX1 and the second pixel PX2 may be surrounded by the first light blocking layer BM1. Accordingly, the light emitting elements ED may be surrounded by the first light blocking layer BM1 in a plan view.

The first light blocking layer BM1 may be disposed in an entire display area DA and may include openings OP that expose the light emitting elements ED of the pixels PX in a plan view. In an embodiment, the first light blocking layer BM1 may include openings OP that are larger than the light emitting elements ED in a plan view and may surround the light emitting elements ED at a position spaced apart from the light emitting elements ED. For example, the first light blocking layer BM1 may surround the emission areas EA of all subpixels SPX disposed in each unit area UNA and may include openings OP that expose the light emitting elements ED of all subpixels SPX.

In an embodiment, the first light blocking layer BM1 may be disposed in the color filter layer CFL of FIG. 3. For example, the first light blocking layer BM1 may be disposed in the color filter layer CFL in the non-emission area and include openings OP corresponding to the emission areas EA.

The first light blocking layer BM1 may be disposed in the non-emission area of all pixels PX of the display area DA including the first pixels PX1 and the second pixels PX2. Accordingly, reflected light caused by external light may be uniformly reduced in the display area DA, and light interference between adjacent pixels PX may be reduced.

In an embodiment, the first light blocking layer BM1 may be opened to a substantially uniform size in the first pixel PX1 and the second pixel PX2. For example, the first light blocking layer BM1 may include openings OP of a same size which correspond to the first emission areas EA1 of the first pixel PX1 and the second pixel PX2 and may include openings OP of a same size which correspond to the second emission areas EA2 of the first pixel PX1 and the second pixel PX2. In an embodiment, the first light blocking layer BM1 may surround the first light emitting element ED1 of the second pixel PX2 at a closer distance to the first light emitting element ED1 of the second pixel PX2 than to the first light emitting element ED1 of the first pixel PX1 and may surround the second light emitting element ED2 of the second pixel PX2 at a closer distance to the second light emitting element ED2 of the second pixel PX2 than to the second light emitting element ED2 of the first pixel PX1. For example, the opening OP of the first light blocking layer BM1 corresponding to the first light emission area EA1 of the first pixel PX1 may be larger than the opening OP of the first light blocking layer BM1 corresponding to the first light emission area EA1 of the second pixel PX2, and the opening OP of the first light blocking layer BM1 corresponding to the second light emission area EA2 of the first pixel PX1 may be larger than the opening OP of the first light blocking layer BM1 corresponding to the second light emission area EA2 of the second pixel PX2 in a plan view.

At least one of the emission areas EA of the second pixel PX2 may be further surrounded by the second light blocking layer BM2. For example, the display device 10 may further include the second light blocking layer BM2 which surrounds the first emission area EA1 and the second emission area EA2 of the second pixel PX2 in a plan view.

The second light blocking layer BM2 may surround the emission areas EA of some of the subpixels SPX disposed in each of the unit areas UNA of the display area DA and may include openings BOP that expose the light emitting elements ED of the some of the subpixels SPX. For example, the second light blocking layer BM2 may surround the emission areas EA of at least some of the subpixels SPX included in the second pixels PX2. In an embodiment, the second light blocking layer BM2 may not be disposed in a first pixel area where the subpixels SPX of each first pixel PX1 are disposed. Accordingly, in an emission mode (e.g., a first emission mode or a third emission mode) in which the first pixels PX1 are driven, the second light blocking layer BM2 may not block most of side light emitted from the first pixels PX1.

In an embodiment, the second light blocking layer BM2 may be disposed only in some of the subpixels SPX constituting each second pixel PX2. For example, the second light blocking layer BM2 may be disposed only in the first subpixel SPX1 and the second subpixel SPX2 of the second pixel PX2 and may not be disposed in the third subpixel SPX3.

The second light blocking layer BM2 may be disposed in the non-emission area of the second pixel PX2. For example, the second light blocking layer BM2 may be disposed in the non-emission area of the first subpixel SPX1 and the second subpixel SPX2 of the second pixel PX2. The second light blocking layer BM2 may surround the first emission area EA1 and the second emission area EA2 of the second pixel PX2 and may include openings BOP that expose the light emitting elements ED disposed in the first emission area EA1 and the second emission area EA2 of the second pixel PX2.

In an embodiment, the second light blocking layer BM2 may be opened to include an opening BOP that is larger than the light emitting element ED of each subpixel SPX in a plan view and may surround the light emitting element ED at a position spaced from the light emitting element ED. For example, the second light blocking layer BM2 may not cover the light emitting element ED in a plan view.

In an embodiment, the second light blocking layer BM2 may be disposed in the light blocking member layer PML of FIG. 3. For example, the second light blocking layer BM2 may be disposed in the light blocking member layer PML on the first light blocking layer BM1 and may be formed in the non-emission area of some subpixels SPX to include openings BOP corresponding to the emission areas EA of the some subpixels SPX.

Side light output rates or side luminance ratios of the first pixel PX1 and the second pixel PX2 may be different due to the second light blocking layer BM2. For example, since most of side light emitted in a lateral direction from the first emission area EA1 and the second emission area EA2 of the second pixel PX2 is blocked by the second light blocking layer BM2, the side luminance ratio of the second pixel PX2 may be significantly reduced. Accordingly, the side luminance ratio and viewing angle of the second pixel PX2 may be significantly reduced compared with the side luminance ratio and viewing angle of the first pixel PX1. The first pixel PX1 may be a pixel whose light emitting area or side luminance ratio is not limited and may also be referred to as a "normal pixel" or a "wide pixel." The second pixel PX2 may be a pixel whose light emitting area or side luminance ratio is reduced compared with that of the first pixel PX1 and may also be referred to as a "narrow pixel."

In an embodiment, side light of the first subpixel SPX1 and the second subpixel SPX2 of the second pixel PX2 may be blocked while side light of the third subpixel SPX3 emitting blue light, which occupies a lowest proportion of luminance among red, green and blue light emitted from the second pixel PX2, may not be blocked. The side luminance ratio of the second pixel PX2 may be reduced by about 90% or more (e.g., about 93.5%) by only blocking the side light of the first subpixel SPX1 and the second subpixel SPX2. For example, the side luminance ratio of the second pixel PX2 may be less than or equal to about 10%. In addition, color information corresponding to about 66% of the color information that can be seen by a user looking at the display device 10 from a specific viewing angle or from the side may be blocked by appropriately blocking the side light of the first subpixel SPX1 and the second subpixel SPX2. Therefore, it may be possible to prevent an image from being seen by the user looking at the display device 10 from the specific viewing angle or from the side.

In an embodiment, the emission areas EA of some subpixels SPX (e.g., light transmitting areas in a plan view) may be narrowed by the second light blocking layer BM2. For example, the second light blocking layer BM2 may include an opening BOP, which is smaller than an opening OP of the first light blocking layer BM1, in a subpixel area where a corresponding subpixel SPX is disposed and may surround a light emitting element ED at a closer distance to the light emitting element ED than the first light blocking layer BM1 in a plan view. The emission areas EA (or light transmitting areas) of subpixels SPX may be primarily defined by the openings OP of the first light blocking layer BM1, and the emission areas EA (or light transmitting areas) of some subpixels SPX surrounded by the second light blocking layer BM2 may be further reduced by the openings BOP of the second light blocking layer BM2. For example, the size of the first emission area EA1 of the second pixel PX2 may be smaller than the size of the first emission area EA1 of the first pixel PX1, and the size of the second emission area EA2 of the second pixel PX2 may be smaller than the size of the second emission area EA2 of the first pixel PX1. Accordingly, the side luminance ratio of the second pixel PX2 may be further reduced. For example, as the size of each opening BOP of the second blocking layer BM2 decreases, the effective light emitting area and luminance of a corresponding subpixel SPX and a second pixel PX2 including the subpixel SPX may decrease, and a side light blocking rate may increase.

However, embodiments are not limited thereto. For example, in subpixels SPX in which the second blocking layer BM2 is disposed, a size of the opening BOP of the second blocking layer BM2 may be same as or greater than a size of the opening OP of the first blocking layer BM1 in a plan view. However, since the second blocking layer BM2 is disposed above the first blocking layer BM1, some of the side light passing through the openings OP of the first blocking layer BM1 may be blocked by the second blocking layer BM2. Accordingly, even if the second blocking layer BM2 is opened to a larger size than the first blocking layer BM1 in some subpixels SPX, the side light output rate of the subpixels SPX may be reduced.

Since the second blocking layer BM2 is disposed in the second pixels PX2 of the display area DA as described above, the side luminance ratio and viewing angle of the second pixels PX2 may be additionally adjusted or limited. For example, the side luminance ratio and viewing angle of the second pixels PX2 may be adjusted or optimized by adjusting or changing at least one of the size of the openings BOP of the second blocking layer BM2 and the distance between the light emitting elements ED of the second pixels PX2 (e.g., the first light emitting elements ED1 and the second light emitting elements ED2 of the second pixels PX2) and the second blocking layer BM2.

In an embodiment, the second light blocking layer BM2 disposed in each unit area UNA may be formed as one pattern. For example, in each unit area UNA, the second light blocking layer BM2 surrounding the first emission area EA1 and the second emission area EA2 of the second pixel PX2 may be connected and formed as one pattern. Accordingly, in a pixel process for forming the pixels PX, the second light blocking layer BM2 may be prevented from moving out of a position or being peeled off and may be stably formed. However, embodiments are not limited thereto, and in another embodiment, the second light blocking layer BM2 surrounding each emission area EA may be formed separately.

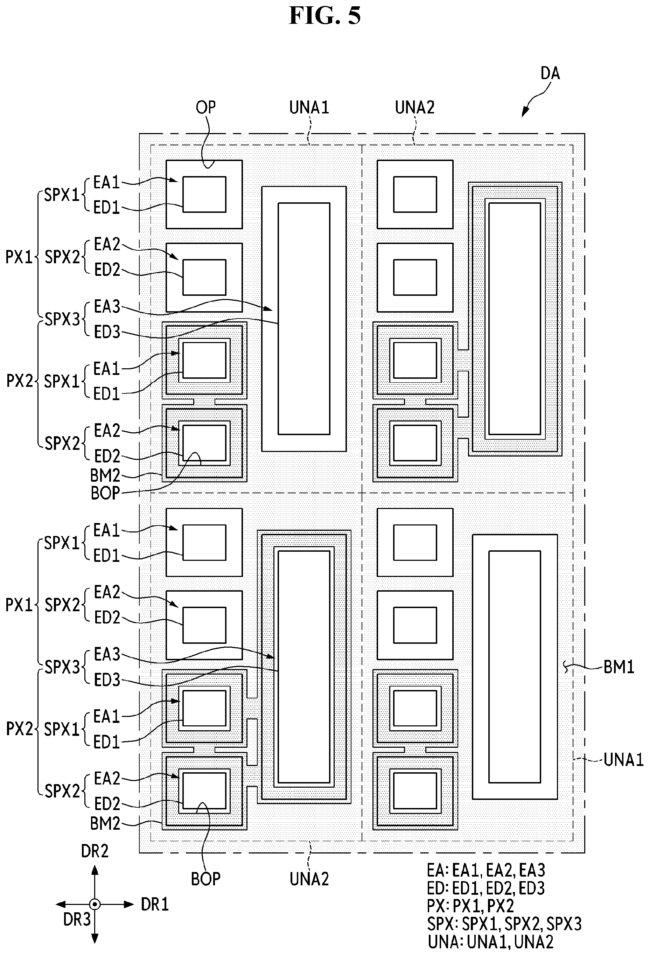

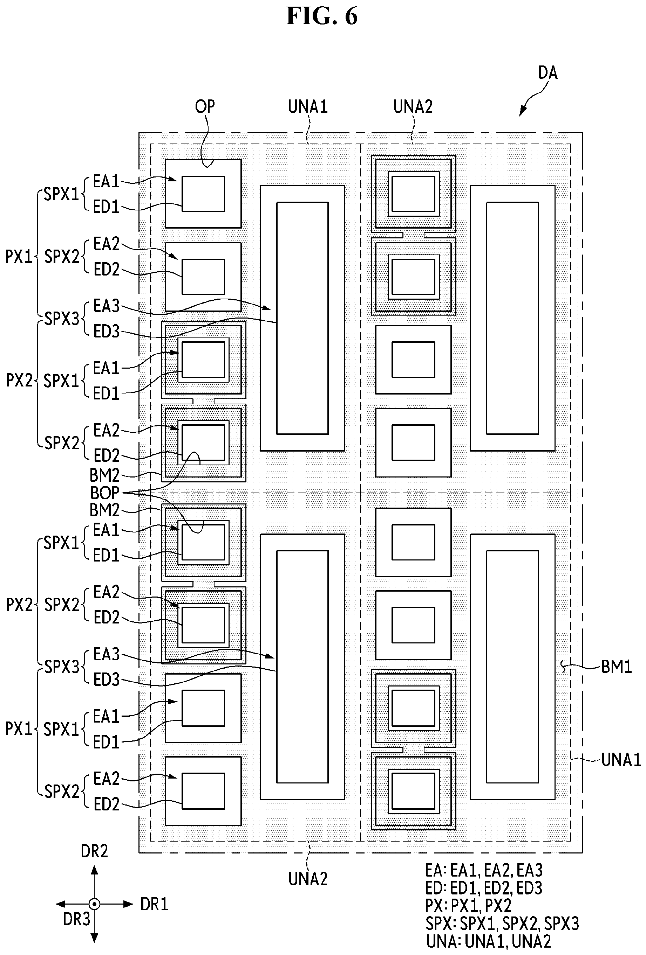

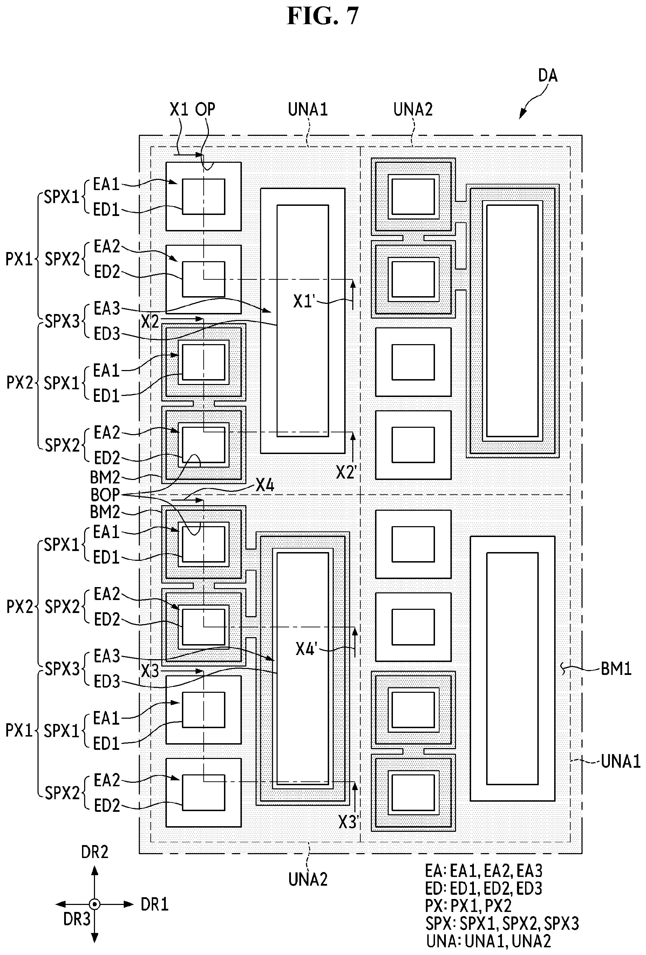

FIG. 5 is a plan view of a display area DA of a display device according to an embodiment. FIG. 6 is a plan view of a display area DA of a display device according to an embodiment. FIG. 7 is a plan view of a display area DA of a display device according to an embodiment. For example, FIGS. 5, 6 and 7 each schematically illustrate light emitting elements ED disposed in a display area DA of a display device 10 according to an embodiment and a first light blocking layer BM1 and a second light blocking layer BM2 disposed around the light emitting elements ED. FIGS. 5, 6 and 7 schematically illustrate embodiments different from the embodiment of FIG. 4 in the arrangement structure of subpixels SPX or of the second light blocking layer BM2. In the following description of the embodiments, a redundant description of elements substantially identical or similar to those of at least one embodiment described earlier will be omitted.

Referring to FIGS. 5, 6 and 7, unit areas UNA of the display area DA may include first unit areas UNA1 and second unit areas UNA2. The first unit areas UNA1 may have substantially a same structure, and the second unit areas UNA2 may have substantially a same structure.

The first unit areas UNA1 and the second unit areas UNA2 may have different structures. For example, the first unit areas UNA1 and the second unit areas UNA2 may have different structures in relation to the arrangement structure of the subpixels SPX or the second light blocking layer BM2.

Each of the first unit areas UNA1 and the second unit areas UNA2 may include a pair of a first pixel PX1 and a second pixel PX2. The pair of the first pixel PX1 and the second pixel PX2 may include first subpixels SPX1 and second subpixels SPX2 and may share a third subpixel SPX3.

In an embodiment, the first unit areas UNA1 and the second unit areas UNA2 may be alternately arranged. For example, the first unit areas UNA1 and the second unit areas UNA2 may be arranged alternately in each of the first direction DR1 and the second direction DR2 and may neighbor each other in the first direction DR1 and the second direction DR2. The alternate arrangement of the first unit areas UNA1 and the second unit areas UNA2 may make the overall image quality or color of the display area DA uniform.

In the embodiment of FIG. 5, the first unit areas UNA1 and the second unit areas UNA2 may have different structures in relation to the second light blocking layer BM2. For example, the second light blocking layer BM2 may have different shapes in the first unit areas UNA1 and the second unit areas UNA2.

In each first unit area UNA1, the second light blocking layer BM2 may not surround a third emission area EA3 in a plan view. For example, in each first unit area UNA1, the second light blocking layer BM2 may surround only a first emission area EA1 and a second emission area EA2 of the second pixel PX2 and may not surround the third emission area EA3.

In each second unit area UNA2, the second light blocking layer BM2 may surround the third emission area EA3 in a plan view. For example, in each second unit area UNA2, the second light blocking layer BM2 may surround the first emission area EA1, the second emission area EA2, and the third emission area EA3 of the second pixel PX2.

A side light output rate of the second pixel PX2 disposed in each second unit area UNA2 may be lower than a side light output rate of the second pixel PX2 disposed in each first unit area UNA1. While the second pixel PX2 may display a bluish side color in each first unit area UNA1, the side color of the second pixel PX2 may not be bluish or may be less bluish in each second unit area UNA2.

By placing the second light blocking layer BM2 in some of the third subpixels SPX3 as described above, it may possible to further reduce a side luminance ratio of the second pixels PX2 in an emission mode (e.g., a privacy mode that limits a viewing angle) in which the second pixels PX2 are driven. Accordingly, the side luminance ratio of the second pixels PX2 may be further reduced in accordance with the purpose for which the second pixels PX2 are driven, and a privacy protection function may be strengthened.

By alternately placing the unit areas UNA having different structures and different light output characteristics (e.g., different side luminance ratios and side colors) as described above, it may be possible to prevent a difference in light output characteristics due to the differential arrangement of the second light blocking layer BM2 from being seen as a line-shaped stain.

In the embodiment of FIG. 6, the first unit areas UNA1 and the second unit areas UNA2 may have different structures in relation to the arrangement position or order of the subpixels SPX. For example, in each first unit area UNA1, the first subpixel SPX1 of the first pixel PX1, the second subpixel SPX2 of the first pixel PX1, the first subpixel SPX1 of the second pixel PX2, and the second subpixel SPX2 of the second pixel PX2 may be sequentially arranged in the second direction DR2. In each second unit area UNA2, the first subpixel SPX1 of the second pixel PX2, the second subpixel SPX2 of the second pixel PX2, the first subpixel SPX1 of the first pixel PX1, and the second subpixel SPX2 of the first pixel PX1 may be sequentially arranged in the second direction DR2. By arranging the subpixels SPX of the first pixel PX1 and the subpixels SPX of the second pixel PX2 in different orders in the first unit areas UNA1 and the second unit areas UNA2 as described above, it may be possible to prevent a difference in light output characteristics due to the arrangement position or order of the subpixels SPX from being seen as a line-shaped stain.

In the embodiment of FIG. 7, the first unit areas UNA1 and the second unit areas UNA2 may have different structures in relation to the second light blocking layer BM2 and the arrangement position or order of the subpixels SPX.

For example, in each first unit area UNA1, the second light blocking layer BM2 may surround only the first emission area EA1 and the second emission area EA2 of the second pixel PX2 and may not surround the third emission area EA3 in a plan view. In each first unit area UNA1, the first subpixel SPX1 of the first pixel PX1, the second subpixel SPX2 of the first pixel PX1, the first subpixel SPX1 of the second pixel PX2, and the second subpixel SPX2 of the second pixel PX2 may be sequentially arranged in the second direction DR2.

On the other hand, in each second unit area UNA2, the second light blocking layer BM2 may surround the first emission area EA1, the second emission area EA2, and the third emission area EA3 of the second pixel PX2 in a plan view. In each second unit area UNA2, the first subpixel SPX1 of the second pixel PX2, the second subpixel SPX2 of the second pixel PX2, the first subpixel SPX1 of the first pixel PX1, and the second subpixel SPX2 of the first pixel PX1 may be sequentially arranged in the second direction DR2.

Accordingly, it may be possible to prevent a difference in light output characteristics due to the differential arrangement of the second light blocking layer BM2 and the arrangement position or order of the subpixels SPX from being seen as a line-shaped stain.

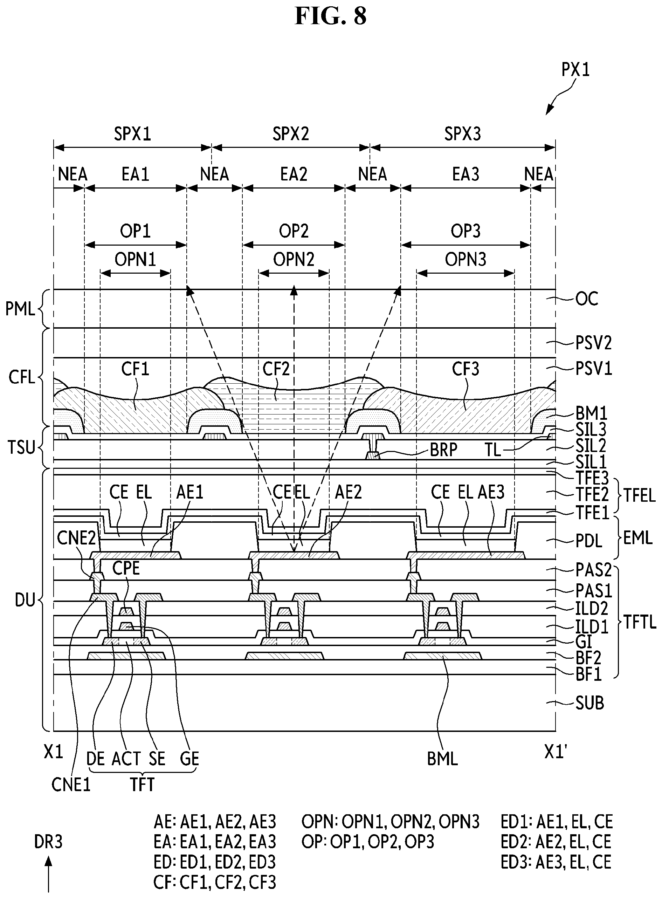

FIG. 8 is a schematic cross-sectional view of a display device 10 according to an embodiment. For example, FIG. 8 schematically illustrates a part of the display device 10 along line X1-X1' of FIG. 7 and schematically illustrates an embodiment of a cross section of a first pixel PX1 disposed in a first unit area UNA1.

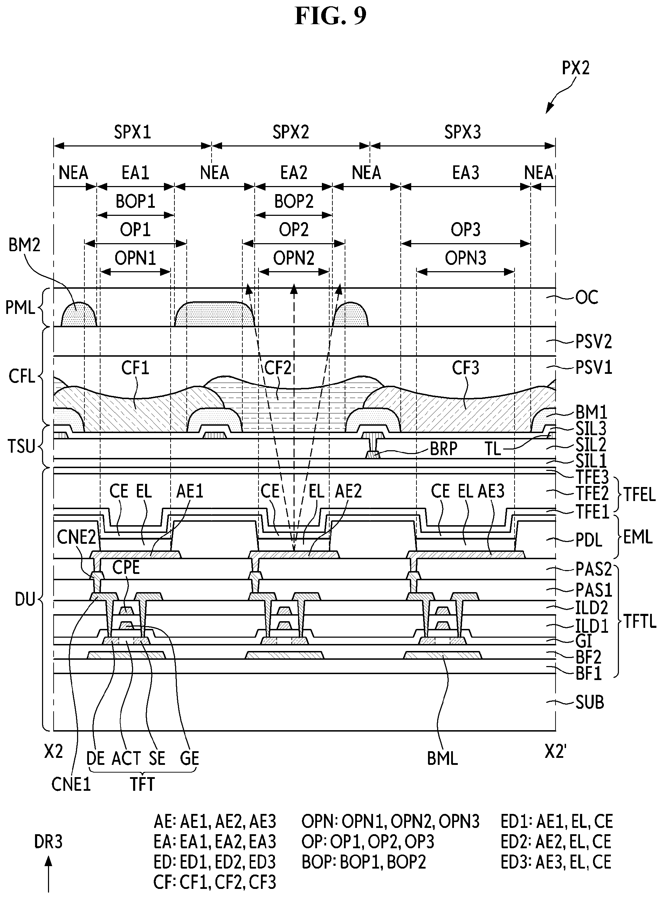

FIG. 9 is a schematic cross-sectional view of the display device 10 according to an embodiment. For example, FIG. 9 schematically illustrates a part of the display device 10 along line X2-X2' of FIG. 7 and schematically illustrates an embodiment of a cross section of a second pixel PX2 disposed in the first unit area UNA1.

The unit areas UNA of FIG. 4 and the first unit areas UNA1 of FIG. 7 may have substantially a same structure. Accordingly, a cross section of each first pixel PX1 of FIG. 4 may correspond to the cross section of the first pixel PX1 illustrated in FIG. 8, and a cross section of each second pixel PX2 of FIG. 4 may correspond to the cross section of the second pixel PX2 illustrated in FIG. 9.

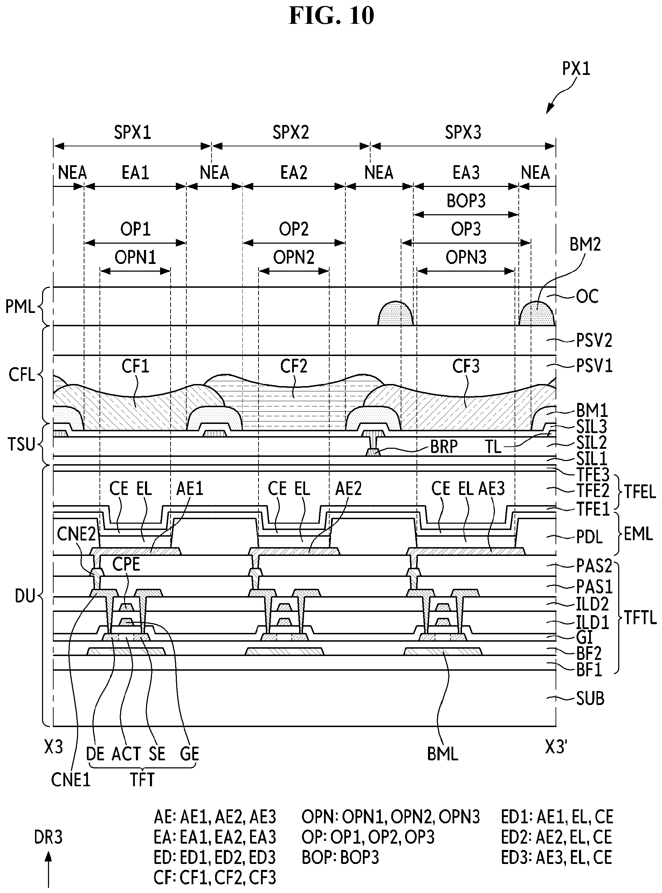

FIG. 10 is a schematic cross-sectional view of the display device 10 according to an embodiment. For example, FIG. 10 schematically illustrates a part of the display device 10 along line X3-X3' of FIG. 7 and schematically illustrates an embodiment of a cross section of a first pixel PX1 disposed in a second unit area UNA2.

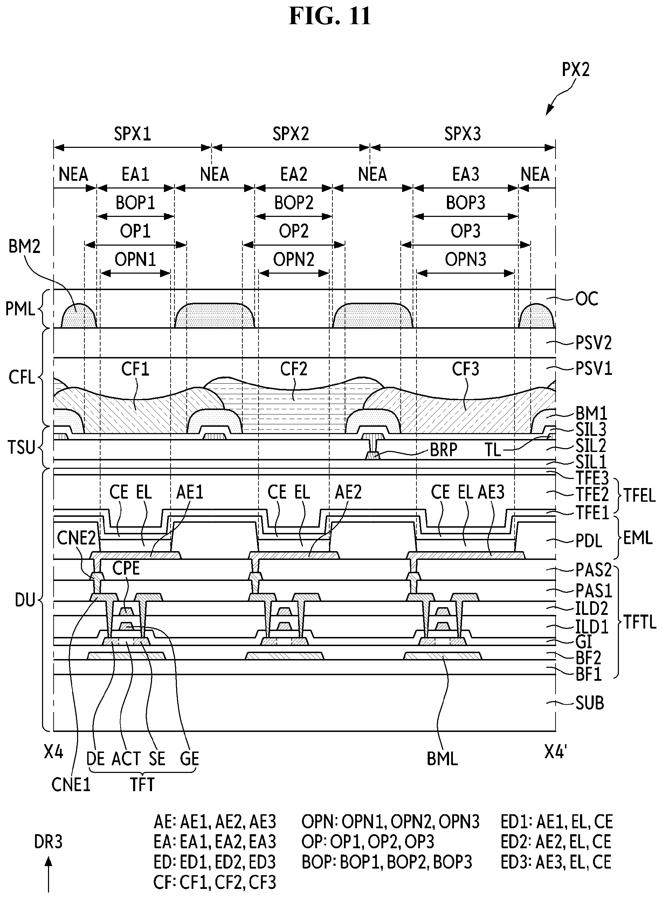

FIG. 11 is a schematic cross-sectional view of the display device 10 according to an embodiment. For example, FIG. 11 schematically illustrates a part of the display device 10 along line X4-X4' of FIG. 7 and schematically illustrates an embodiment of a cross section of a second pixel PX2 disposed in the second unit area UNA2.

Referring to FIGS. 8 through 11 in addition to FIGS. 1 through 7, the display device 10 according to an embodiment may include a display layer DU, a touch sensing layer TSU, a color filter layer CFL, and a light blocking member layer PML. The display layer DU may include a substrate SUB, a thin-film transistor layer TFTL, a light emitting element layer EML, and an encapsulation layer TFEL. The touch sensing layer TSU may include touch electrodes TL and bridge patterns BRP. The color filter layer CFL may include a first light blocking layer BM1 and color filters CF. The light blocking member layer PML may include a second light blocking layer BM2.

The light blocking layer BM2 may be located outside the emission areas EA, in particular at least outside the third emission area EA3. In an embodiment, light blocking layer BM2 may be located outside each of the emission areas EA1, EA2, or each of the emission areas EA1, EA2 and EA3, see figs. 9, 10 and 11.

The substrate SUB may be a base substrate or a base member for forming the display panel 100. In an embodiment, the substrate SUB may be, but is not limited to, a flexible substrate that can be bent, folded, rolled, etc.

The substrate SUB may include a display area DA including emission areas EA of pixels PX and a non-emission area NEA surrounding the emission areas EA. The substrate SUB may further include a peripheral area located around the display area DA. For example, the substrate SUB may further include a non-display area NDA and a sub-area SBA as illustrated in FIGS. 2 and 3.

The thin-film transistor layer TFTL may include a first buffer layer BF1, bottom metal layers BML, a second buffer layer BF2, thin-film transistors TFT, a gate insulating layer GI, a first interlayer insulating layer ILD1, capacitor electrodes CPE, a second interlayer insulating layer ILD2, first connection electrodes CNE1, a first protective layer PAS1, second connection electrodes CNE2, and a second protective layer PAS2. However, the number or types of conductive layers and insulating layers that constitute the thin-film transistor layer TFTL and/or the structure or type of the thin-film transistors TFT may be variously changed according to embodiments.

The first buffer layer BF1 may be disposed on the substrate SUB. The first buffer layer BF1 may include at least one inorganic layer that can prevent penetration of air or moisture. In another embodiment, the first buffer layer BF1 may be omitted.

The bottom metal layers BML may be disposed on the first buffer layer BF1. In an embodiment, each of the bottom metal layers BML may be a single layer or a multilayer made of at least one of molybdenum (Mo), aluminum (Al), chromium (Cr), gold (Au), titanium (Ti), nickel (Ni), neodymium (Nd), copper (Cu), and an alloy thereof. The bottom metal layers

BML may be disposed under the thin-film transistors TFT. For example, the bottom metal layers BML may be disposed under semiconductor layers ACT of the thin-film transistors TFT to function as light blocking patterns.

The second buffer layer BF2 may cover the first buffer layer BF1 and the bottom metal layers BML. The second buffer layer BF2 may include at least one inorganic layer that can prevent penetration of air or moisture.

The thin-film transistors TFT may be disposed on the second buffer layer BF2 and may be provided in pixel circuits of subpixels SPX, respectively. FIGS. 8 through 11 schematically illustrate one thin-film transistor TFT (e.g., a thin-film transistor TFT electrically connected to each light emitting element ED) among the thin-film transistors TFT that may be provided in each of the pixel circuits of the subpixels SPX. Each of the thin-film transistors TFT illustrated in FIGS. 8 through 11 may be a switching transistor or a driving transistor that constitutes a pixel circuit. Each of the thin-film transistors TFT may include a semiconductor layer ACT, a source electrode SE, a drain electrode DE, and a gate electrode GE.

The semiconductor layer ACT may be disposed on the second buffer layer BF2. The semiconductor layer ACT may overlap a bottom metal layer BML and the gate electrode GE in a thickness direction (e.g., the third direction DR3) and may be insulated from the gate electrode GE by the gate insulating layer GI. Portions of the semiconductor layer ACT may be made conductive to form the source electrode SE (or source region) and the drain electrode DE (or drain region).

The gate electrode GE may be disposed on the gate insulating layer GI. The gate electrode GE may overlap the semiconductor layer ACT in the thickness direction with the gate insulating layer GI interposed between the gate electrode GE and the semiconductor layer ACT.

The gate insulating layer GI may be disposed on the semiconductor layers ACT. For example, the gate insulating layer GI may cover the semiconductor layers ACT and the second buffer layer BF2 and may be disposed between the semiconductor layers ACT and the gate electrodes GE. The gate insulating layer GI may include contact holes through which the first connection electrodes CNE1 pass.

The first interlayer insulating layer ILD1 may cover the gate electrodes GE and the gate insulating layer GI. The first interlayer insulating layer ILD1 may include contact holes through which the first connection electrodes CNE1 pass. The contact holes of the first interlayer insulating layer ILD1 may be connected to the contact holes of the gate insulating layer GI and contact holes of the second interlayer insulating layer ILD2.

The capacitor electrodes CPE may be disposed on the first interlayer insulating layer ILD1. The capacitor electrodes CPE may overlap the gate electrodes GE in the thickness direction. The capacitor electrodes CPE and the gate electrodes GE may form a capacitor. For example, a capacitor of the pixel circuits may be formed by the capacitor electrodes CPE and the gate electrodes GE.

The second interlayer insulating layer ILD2 may cover the capacitor electrodes CPE and the first interlayer insulating layer ILD1. The second interlayer insulating layer ILD2 may include contact holes through which the first connection electrodes CNE1 pass. The contact holes of the second interlayer insulating layer IL2 may be connected to the contact holes of the first interlayer insulating layer ILD1 and the contact holes of the gate insulating layer GI.

The first connection electrodes CNE1 may be disposed on the second interlayer insulating layer ILD2. The first connection electrodes CNE1 may electrically connect the drain electrodes DE of the thin-film transistors TFT to the second connection electrodes CNE2. In an embodiment, another connection electrode may be electrically connected to the source electrode SE of each of the thin-film transistors TFT. In case that the type of the thin-film transistors TFT and/or the structure of the pixel circuits change, the first connection electrodes CNE1 may electrically connect the source electrodes SE of the thin-film transistors TFT to the second connection electrodes CNE2. The first connection electrodes CNE1 may be in contact with and/or connected to the drain electrodes DE of the thin-film transistors TFT through the contact holes formed in the second interlayer insulating layer ILD2, the first interlayer insulating layer ILD1, and the gate insulating layer GI.

The first protective layer PAS1 may cover the first connection electrodes CNE1 and the second interlayer insulating layer ILD2. The first protective layer PAS1 may protect the thin-film transistors TFT. The first protective layer PAS1 may include contact holes through which the second connection electrodes CNE2 pass.

The second connection electrodes CNE2 may be disposed on the first protective layer PAS1. The second connection electrodes CNE2 may electrically connect the first connection electrodes CNE1 to pixel electrodes AE of light emitting elements ED. The second connection electrodes CNE2 may be in contact with and/or connected to the first connection electrodes CNE1 through the contact holes formed in the first protective layer PAS1. The second connection electrodes CNE2 may be in contact with and/or connected to the pixel electrodes AE of the light emitting elements ED through contact holes formed in the second protective layer PAS2. In an embodiment, the thin-film transistor layer TFTL may not include the second connection electrodes CNE2, and the pixel electrodes AE of the light emitting elements ED may be connected to (e.g., directly connected to) the first connection electrodes CNE1 (or electrodes of the thin-film transistors TFT).

The second protective layer PAS2 may cover the second connection electrodes CNE2 and the first protective layer PAS1. The second protective layer PAS2 may include the contact holes through which the pixel electrodes AE of the light emitting elements ED pass. In an embodiment, the thin-film transistor layer TFTL may not include the second connection electrodes CNE2 and the second protective layer PAS2, and the pixel electrodes AE of the light emitting elements ED may be disposed on the first protective layer PAS1.

The light emitting element layer EML may be disposed on the thin-film transistor layer TFTL. The light emitting element layer EML may include the light emitting elements ED of the subpixels SPX disposed in each unit area UNA and a pixel defining layer PDL.

The light emitting elements ED may be disposed in the emission areas EA, respectively. In FIGS. 8 through 11, the emission areas EA are defined based on the first light blocking layer BM1 and the second light blocking layer BM2. For example, in FIGS. 8 through 11, the emission areas EA may be areas where the light emitting elements ED are exposed by openings OP and BOP of the first light blocking layer BM1 and the second light blocking layer BM2. However, embodiments are not limited thereto, and light emitting element areas defined by the pixel defining layer PDL (e.g., areas where the pixel electrodes AE of the light emitting elements ED are exposed by openings OPN of the pixel defining layer PDL) may be defined as the emission areas EA.

Each of the light emitting elements ED may include a pixel electrode AE (e.g., a first electrode or an anode of the light emitting element ED), a light emitting layer EL, and a common electrode CE (e.g., a second electrode or a cathode of the light emitting element ED). For example, a first light emitting element ED1 may include a first pixel electrode AE1 and a light emitting layer EL and a common electrode CE sequentially disposed on the first pixel electrode AE1. A second light emitting element ED2 may include a second pixel electrode AE2 and a light emitting layer EL and the common electrode CE sequentially disposed on the second pixel electrode AE2. A third light emitting element ED3 may include a third pixel electrode AE3 and a light emitting layer EL and the common electrode CE sequentially disposed on the third pixel electrode AE3.

The pixel electrodes AE may be disposed on the second protective layer PAS2. A pixel electrodes AE may be respectively disposed in emission areas EA corresponding to an opening OPN of the pixel defining layer PDL. For example, the first pixel electrode AE1, the second pixel electrode AE2, and the third pixel electrode AE3 may be disposed in a first emission area EA1, a second emission area EA2, and a third emission area EA3, respectively.

In an embodiment, at least a portion of each of the pixel electrodes AE may be exposed without being covered by the pixel defining layer PDL in a plan view. For example, each first pixel electrode AE1 may have most of the area including a central portion exposed by a first opening OPN1 of the pixel defining layer PDL, each second pixel electrode AE2 may have most of the area including a central portion exposed by a second opening OPN2 of the pixel defining layer PDL, and each third pixel electrode AE3 may have most of the area including a central portion exposed by a third opening OPN3 of the pixel defining layer PDL. Edge portions of the pixel electrodes AE may be covered by the pixel defining layer PDL.

The light emitting layers EL may be disposed on portions of the pixel electrodes AE exposed by the openings OPN of the pixel defining layer PDL, respectively. Accordingly, the light emitting elements ED may be disposed in the emission areas EA, respectively. For example, the light emitting elements ED may be disposed in the openings OPN of the pixel defining layer PDL. The areas where the light emitting elements ED are formed in the openings OPN of the pixel defining layer PDL may also be referred to as light emitting element areas. Each of the light emitting element areas may be a whole or part of an emission area EA where a corresponding light emitting element ED is disposed.

Each of the pixel electrodes AE may be electrically connected to an electrode of a thin-film transistor TFT. For example, each of the pixel electrodes AE may be electrically connected to a drain electrode DE of a thin-film transistor TFT through a first connection electrode CNE1 and a second connection electrode CNE2.

The light emitting layers EL may be disposed on the pixel electrodes AE. In an embodiment, each of the light emitting layers EL may be, but is not limited to, an organic light emitting layer made of an organic material.

In an embodiment, the light emitting layers EL of the first light emitting element ED1, the second light emitting element ED2, and the third light emitting element ED3 may emit light of different colors. For example, the light emitting layer EL of the first light emitting element ED1 may emit light of a first color, for example, red light, the light emitting layer EL of the second light emitting element ED2 may emit light of a second color, for example, green light, and the light emitting layer EL of the third light emitting element ED3 may emit light of a third color, for example, blue light.

However, embodiments are not limited thereto. For example, in another embodiment, the light emitting layers EL of the light emitting elements ED may be formed as a single common layer disposed entirely on different pixel electrodes AE and the pixel defining layer PDL, and the light emitting layers EL disposed on different pixel electrodes AE may emit light of a same color. The display device 10 may further include a color adjustment layer (e.g., a color conversion layer including wavelength conversion patterns and/or a color adjustment layer including color filters CF) disposed on the light emitting elements ED.

The common electrode CE may be disposed on the light emitting layer EL of each of the light emitting elements ED. In an embodiment, the common electrode CE may be formed as a single common layer disposed in the entire display area DA, and the light emitting elements ED may share one common electrode CE. The common electrode CE may receive a common voltage (e.g., a second pixel voltage or a cathode voltage).

The pixel defining layer PDL may include the openings OPN corresponding to the emission areas EA and may be disposed on the second protective layer PAS2 and a portion of each of the pixel electrodes AE. For example, the pixel defining layer PDL may be disposed at least in the non-emission area NEA and may include the first opening OPN1 disposed in the first emission area EA1, the second opening OPN2 disposed in the second emission area EA2, and the third opening OPN3 disposed in the third emission area EA3.

The openings OPN of the pixel defining layer PDL may have sizes corresponding to sizes of the emission areas EA, respectively. In an embodiment, the openings OPN of the pixel defining layer PDL may have smaller sizes than the emission areas EA, respectively, and may be disposed inside the emission areas EA. In an embodiment, the openings OPN of the pixel defining layer PDL and the emission areas EA may have substantially a same size, respectively. The pixel defining layer PDL may overlap the first light blocking layer BM1 and the second light blocking layer BM2 in the thickness direction.

In an embodiment, the pixel defining layer PDL may be opened by substantially a same area or ratio in a first pixel area where each first pixel PX1 is disposed and in a second pixel area where each second pixel PX2 is disposed. For example, the size of the first opening OPN1 disposed in the first emission area EA1 of the first pixel PX1 and the size of the first opening OPN1 disposed in the first emission area EA1 of the second pixel PX2 may be substantially the same or similar, and the size of the second opening OPN2 disposed in the second emission area EA2 of the first pixel PX1 and the size of the second opening OPN2 disposed in the second emission area EA2 of the second pixel PX2 may be substantially the same or similar. The pixel defining layer PDL may be opened by substantially a same area or ratio in the first unit area UNA1 and the second unit area UNA2. For example, the pixel defining layer PDL may be uniformly opened regardless of the type of the subpixels SPX or the pixels PX which varies according to whether the second light blocking layer BM2 is disposed.

In an embodiment, the pixel defining layer PDL may include a light absorbing material to prevent light reflection. For example, the pixel defining layer PDL may include a polyimide (PI)-based binder and a pigment in which red, green, and blue are mixed together. For example, the pixel defining layer PDL may include a cardo-based binder resin and a mixture of a lactam black pigment and a blue pigment. For example, the pixel defining layer PDL may include carbon black.

The encapsulation layer TFEL may be disposed on the common electrode CE and cover the light emitting elements ED. The encapsulation layer TFEL may include at least one inorganic layer to prevent oxygen or moisture from penetrating into the light emitting element layer EML. The encapsulation layer TFEL may include at least one organic layer to protect the light emitting element layer EML from foreign substances such as dust.

In an embodiment, the encapsulation layer TFEL may include a first encapsulation layer TFE1, a second encapsulation layer TFE2, and a third encapsulation layer TFE3 sequentially disposed on the light emitting elements ED. The first encapsulation layer TFE1 and the third encapsulation layer TFE3 may be inorganic layers, and the second encapsulation layer TFE2 may be an organic layer. For example, the first encapsulation layer TFE1 and the third encapsulation layer TFE3 may include an inorganic insulating material, and the second encapsulation layer TFE2 may include an organic insulating material.

The touch sensing layer TSU may be disposed on the encapsulation layer TFEL. For example, the touch sensing layer TSU may be disposed between the display layer DU and the color filter layer CFL. However, the position of the touch sensing layer TSU may vary according to embodiments.

In an embodiment, the touch sensing layer TSU and the display layer DU may be integrated, or the display device 10 may not include a separate touch sensing layer TSU, and the color filter layer CFL may be disposed on (e.g., directly disposed on) the display layer DU.

The touch sensing layer TSU may include a first insulating layer SIL1, a second insulating layer SIL2, the touch electrodes TL, and a third insulating layer SIL3. In an embodiment, one of the first insulating layer SIL1 and the third insulating layer SIL3 may be omitted.

The touch sensing layer TSU may include conductive patterns including the touch electrodes TL. The conductive patterns may be sensing patterns used to detect a touch input. For example, the conductive patterns of the touch sensing layer TSU may be utilized to sense a change in electrical characteristics (e.g., a change in capacitance) according to a touch input and detect the touch input. In an embodiment, the conductive patterns of the touch sensing layer TSU may further include bridge patterns BRP for connecting the touch electrodes TL (or electrode cells constituting the touch electrodes TL) in a desired shape and/or structure. In an embodiment, the bridge patterns BRP may be disposed on the first insulating layer SIL1, and the touch electrodes TL may be disposed on the second insulating layer SIL2. However, positions of the bridge patterns BRP and the touch electrodes TL may vary according to embodiments.

In an embodiment, the touch electrodes TL may be formed as mesh patterns including openings that expose the emission areas EA of the subpixels SPX in a plan view. For example, each touch electrode TL or each of multiple electrode cells constituting the touch electrode TL may be a mesh pattern composed of thin lines which are disposed in the non-emission area NEA and overlap the first light blocking layer BM1 in the thickness direction. The touch sensing layer TSU may include multiple touch electrodes TL disposed in the display area DA.

In an embodiment, the conductive patterns of the touch sensing layer TSU may be disposed in the non-emission area NEA around the emission areas EA and may be covered by the first light blocking layer BM1. Accordingly, the conductive patterns of the touch sensing layer TSU may be prevented from being seen by a user.

The first insulating layer SIL1 may be disposed on the encapsulation layer TFEL. The first insulating layer SIL1 may have an insulating function and an optical function. In an embodiment, the first insulating layer SIL1 may include at least one inorganic layer.

The bridge patterns BRP may be disposed on the first insulating layer SIL1. Each of the bridge patterns BRP may include a conductive material and may be formed as a single layer or a multilayer.

The second insulating layer SIL2 may be disposed on the bridge patterns BRP. For example, the second insulating layer SIL2 may cover the bridge patterns BRP and the first insulating layer SIL1 and may be disposed between the touch electrodes TL and the bridge patterns BRP. The second insulating layer SIL2 may include contact holes, through which the touch electrodes TL (or the bridge patterns BRP) pass, in portions where the touch electrodes TL and the bridge patterns BRP are connected.

The second insulating layer SIL2 may have an insulating function and an optical function. In an embodiment, the second insulating layer SIL2 may include at least one inorganic layer or at least one organic layer.

The touch electrodes TL (or some of the touch electrodes TL of the display area DA) may be disposed on the second insulating layer SIL2. Each of the touch electrodes TL may include a conductive material and may be formed as a single layer or a multilayer.

The third insulating layer SIL3 may be disposed on the touch electrodes TL. For example, the third insulating layer SIL3 may cover the touch electrodes TL and the second insulating layer SIL2. The third insulating layer SIL3 may include at least one inorganic layer or at least one organic layer.

The color filter layer CFL may be disposed on the touch sensing layer TSU (or the display layer DU). The color filter layer CFL may include the first light blocking layer BM1, the color filters CF, and at least one passivation layer. For example, the color filter layer CFL may include the first light blocking layer BM1, the color filters CF, a first passivation layer PSV1, and a second passivation layer PSV2.

The first light blocking layer BM1 may be disposed on the touch sensing layer TSU. The first light blocking layer BM1 may include a light blocking material (e.g., a light absorbing material) such as a black matrix material.

The first light blocking layer BM1 may be disposed in the non-emission area NEA and may include openings OP that expose the light emitting elements ED in a plan view. For example, the first light blocking layer BM1 may include a first opening OP1 disposed in the first emission area EA1 to expose the first light emitting element ED1, a second opening OP2 disposed in the second emission area EA2 to expose the second light emitting element ED2, and a third opening OP3 disposed in the third emission area EA3 to expose the third light emitting element ED3.

The color filters CF may be disposed on the touch sensing layer TSU and the first light blocking layer BM1. The color filters CF may be disposed in the emission areas EA to overlap the light emitting elements ED in the thickness direction, respectively. In an embodiment, the color filters CF may also be disposed around the emission areas EA, respectively, and at least two adjacent color filters CF may overlap each other in the thickness direction between the emission areas EA. For example, the color filters CF may cover the light emitting elements ED respectively disposed in the emission areas EA and may extend to the non-emission area NEA around the emission areas EA to overlap the first light blocking layer BM1 in the thickness direction.

The color filters CF may include a first color filter CF1 disposed in the first emission area EA1, a second color filter CF2 disposed in the second emission area EA2, and a third color filter CF3 disposed in the third emission area EA3. Each of the color filters CF may include a colorant such as a dye or pigment that absorbs light in wavelength bands other than light in a specific wavelength band.

The first color filters CF1 may pass light of the first color emitted from the first light emitting elements ED1 and absorb and/or block light of other colors (e.g., light of the second color and light of the third color). For example, each first color filter CF1 may be a red color filter that passes only red light emitted from a first light emitting element ED1.

The second color filters CF2 may pass light of the second color emitted from the second light emitting elements ED2 and absorb and/or block light of other colors (e.g., light of the first color and light of the third color). For example, each second color filter CF2 may be a green color filter that passes only green light emitted from a second light emitting element ED2.

The third color filters CF3 may pass light of the third color emitted from the third light emitting elements ED3 and absorb and/or block light of other colors (e.g., light of the first color and light of the second color). For example, each third color filter CF3 may be a blue color filter that passes only blue light emitted from a third light emitting element ED3.

Although FIGS. 8 through 11 illustrates an embodiment in which the color filters CF are formed as individual patterns corresponding to the emission areas EA, respectively, embodiments are not limited thereto. For example, in another embodiment, the color filters CF may be formed in the entire display area DA. For example, the first color filter CF1 may be formed in the entire display area DA and include openings corresponding to the second emission areas EA2 and the third emission areas EA3, the second color filter CF2 may be formed in the entire display area DA and include openings corresponding to the first emission areas EA1 and the third emission areas EA3, and the third color filter CF3 may be formed in the entire display area DA and include openings corresponding to the first emission areas EA1 and the second emission areas EA2.

Although FIGS. 8 through 11 illustrates an embodiment in which the first light blocking layer BM1 is formed as a separate light blocking pattern from the color filters CF, embodiments are not limited thereto. For example, in another embodiment, the first light blocking layer BM1 may be formed as a part of the color filters CF instead of being formed as a separate first light blocking layer BM1. For example, the first light blocking layer BM1 may be formed by stacking the first color filter CF1, the second color filter CF2, and the third color filter CF3 in the non-emission area NEA.

Since the color filters CF and the first light blocking layer BM1 are disposed on the display layer DU, the intensity of reflected light caused by external light may be reduced.

The first passivation layer PSV1 and the second passivation layer PSV2 may be sequentially disposed on the first light blocking layer BM1 and the color filters CF. The first passivation layer PSV1 and the second passivation layer PSV2 may be disposed over the entire display area DA to flatten steps caused by the color filters CF and the first light blocking layer BM1.

The first passivation layer PSV1 and the second passivation layer PSV2 may be light transmitting layers. For example, the first passivation layer PSV1 and the second passivation layer PSV2 may include a colorless light-transmitting organic material such as an acrylic resin.

The light blocking member layer PML may be disposed on the color filter layer CFL. The light blocking member layer PML may include the second light blocking layer BM2 and an overcoat layer OC.

The second light blocking layer BM2 may be disposed on the color filter layer CFL. The second light blocking layer BM2 may include a light blocking material (e.g., a light absorbing material) such as a black matrix material. The material of the first light blocking layer BM1 and the material of the second light blocking layer BM2 may be the same or different.

The second light blocking layer BM2 may be disposed only in some subpixels SPX. For example, the second light blocking layer BM2 may be disposed only in at least some of the subpixels SPX of the second pixels PX2 to surround the emission areas EA of the at least some of the subpixels SPX in a plan view. For example, the second light blocking layer BM2 may be disposed in the non-emission area NEA of a first subpixel SPX1 and a second subpixel SPX2 of the second pixel PX2 in the first unit area UNA1 to surround the first emission area EA1 and the second emission area EA2 of the second pixel PX2 and may be disposed in the non-emission area NEA of a first subpixel SPX1, a second subpixel SPX2, and a third subpixel SPX3 of the second pixel PX2 in the second unit area UNA2 to surround the first emission area EA1, the second emission area EA2, and the third emission area EA3 of the second pixel PX2. The second light blocking layer BM2 may include a first opening BOP1 and a second opening BOP2 which expose the first light emitting element ED1 and the second light emitting element ED2 of the second pixel PX2 in the first unit area UNA1 and may include a first opening BOP1, a second opening BOP2, and a third opening BOP3 which expose the first light emitting element ED1, the second light emitting element ED2, and the third light emitting element ED3 of the second pixel PX2 in the second unit area UNA2.

A side light output rate and viewing angle of the second pixels PX2 may be reduced by the second light blocking layer BM2. For example, as indicated by dotted arrows in FIGS. 8 and 9, at least a portion of side light emitted from the second subpixel SPX2 included in the second pixel PX2 may be blocked by the second light blocking layer BM2. Accordingly, a side luminance ratio of the second subpixel SPX2 included in the second pixel PX2 may be lower than a side luminance ratio of the second subpixel SPX2 included in the first pixel PX1.

In an embodiment, in the pixels PX or the subpixels SPX in which the second light blocking layer BM2 is disposed, the openings BOP of the second light blocking layer BM2 may have a larger size than the openings OPN of the pixel defining layer PDL and a smaller size than the openings OP of the first light blocking layer BM1. However, embodiments are not limited thereto. For example, the size, shape, and/or position of the second light blocking layer BM2 may be adjusted or changed according to the side luminance ratio or viewing angle range required by the second pixel PX2.

The overcoat layer OC may be disposed on the second light blocking layer BM2. The overcoat layer OC may cover the color filter layer CFL and the second light blocking layer BM2.

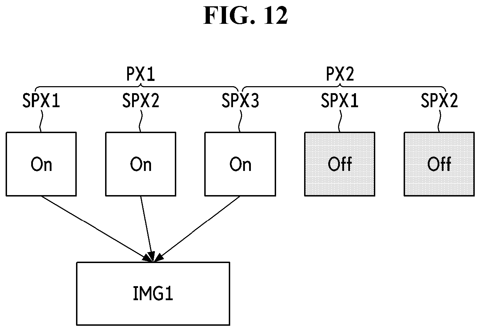

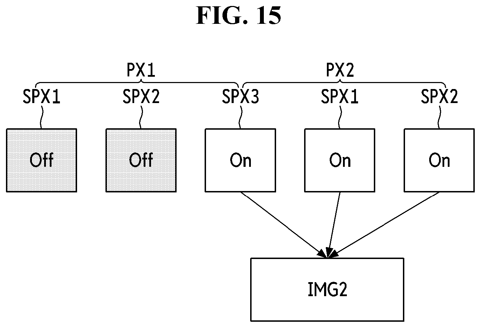

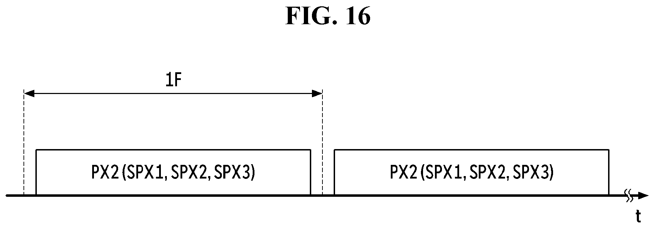

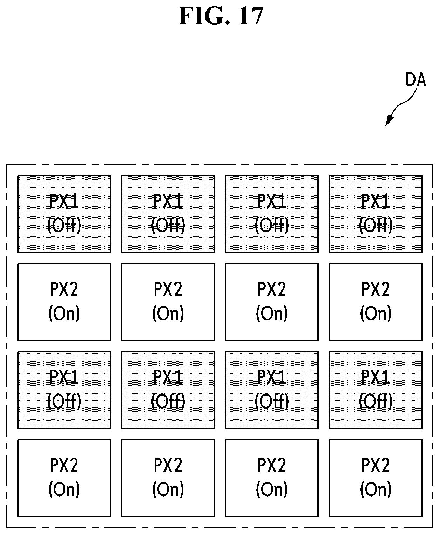

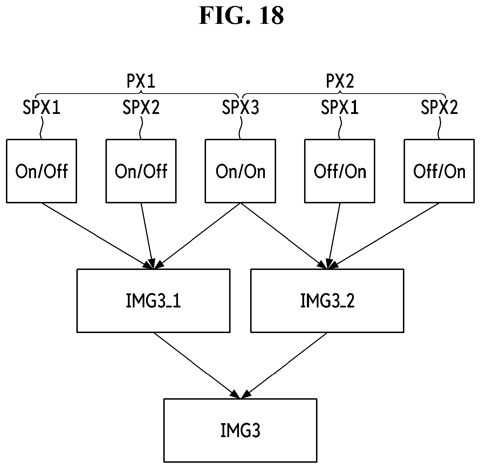

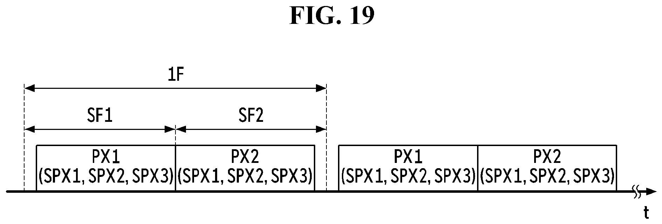

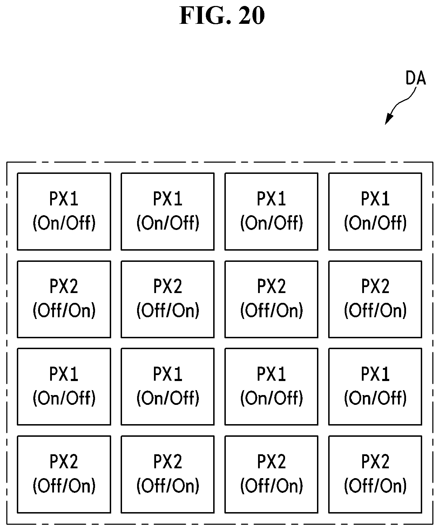

FIGS. 12 through 20 are schematic diagrams illustrating a method of driving a display device according to an embodiment. For example, FIGS. 12 through 14 schematically illustrate an embodiment of a method of driving a display device 10 in response to a first emission mode. FIGS. 15 through 17 schematically illustrate an embodiment of a method of driving the display device 10 in response to a second emission mode. FIGS. 18 through 20 schematically illustrate an embodiment of a method of driving the display device 10 in response to a third emission mode.

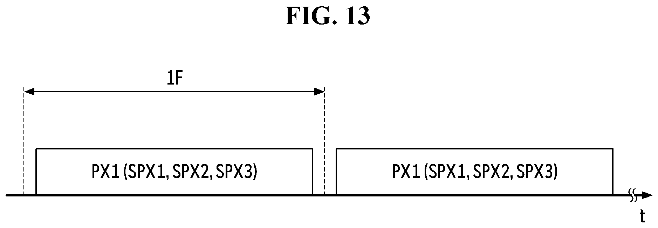

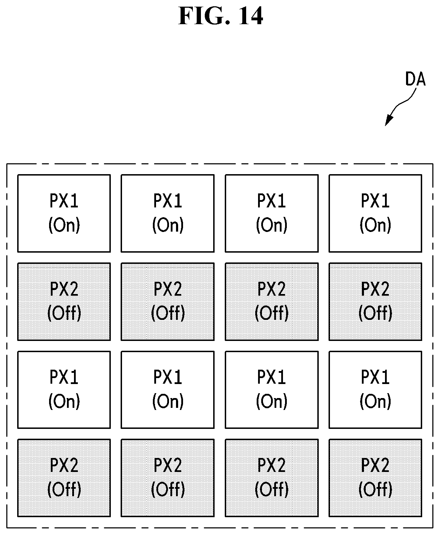

FIGS. 12, 15 and 18 schematically illustrate a method of driving a pair of a first pixel PX1 and a second pixel PX2 in response to the first emission mode, the second emission mode, and the third emission mode, respectively. FIGS. 13, 16 and 19 schematically illustrate driving timings of a first pixel PX1 and/or a second pixel PX2 according to time t in response to the first emission mode, the second emission mode, and the third emission mode, respectively. FIGS. 14, 17 and 20 schematically illustrate a method of driving first pixels PX1 and second pixels PX2 disposed in a display area DA in response to the first emission mode, the second emission mode, and the third emission mode, respectively.

The first pixels PX1 and the second pixels PX2 may be driven in different ways in response to the first emission mode, the second emission mode, and the third emission mode. For example, a display driver 200 (see FIGS. 2 and 3) connected to subpixels SPX of the first pixels PX1 and the second pixels PX2 through data lines may output driving signals, which correspond to each emission mode, to the data lines, respectively, to drive the first pixels PX1 and the second pixels PX2 in a form corresponding to each emission mode.

Referring to FIGS. 12 through 14, an image IMG1 of each frame may be displayed by driving the first pixels PX1 in each frame period in response to the first emission mode (also referred to as a "first driving mode").

In the first emission mode, only a first pixel PX1 among the first pixel PX1 and a second pixel PX2 which are disposed in each unit area UNA and share one third subpixel SPX3 may be driven, and a gray level and color of data corresponding to the unit area UNA among image data of one frame may be expressed by the first pixel PX1. For example, in the first emission mode, a first subpixel SPX1, a second subpixel SPX2, and the third subpixel SPX3 of the first pixel PX1 disposed in each unit area UNA may be driven during one frame period 1F, and accordingly, the gray level and color of each data may be expressed.

While the display device 10 is driven in the first emission mode, the second pixels PX2 may be turned off. For example, a gate driver and/or the display driver 200 may supply driving signals, which may turn off the second pixels PX2, to the second pixels PX2 in response to the first emission mode, thereby turning off the second pixels PX2. For example, in the first emission mode, a first subpixel SPX1 and a second subpixel SPX2 of the second pixel PX2 disposed in each unit area UNA may be turned off.

The first pixels PX1 may have a greater light output angle and a greater side luminance ratio than the second pixels PX2. The first emission mode for displaying an image using the first pixels PX1 may be a normal mode in which the viewing angle of an image displayed in the display area DA is not limited, for example, may be a wide viewing angle mode. For example, while the display device 10 is driven in the first emission mode, the side luminance ratio at a viewing angle of 45° may be greater than or equal to about 20%. Accordingly, an image may be seen even in case that the display device 10 is viewed from the side.

In the first emission mode, an image having a resolution corresponding to the number, arrangement structure, and/or density of the first pixels PX1 disposed in the display area DA may be displayed. For example, the display driver 200 may supply driving signals corresponding to the first emission mode to the first pixels PX1. For example, in response to the first emission mode, the display driver 200 may convert (or rearrange) image data received from the outside into image data corresponding to the resolution of the first pixels PX1 and supply data signals of each frame which correspond to the converted image data to the first pixels PX1 through the data lines. In response to the first emission mode, the display driver 200 may generate data signals by applying a first gamma value set according to emission characteristics of the first pixels PX1.

Referring to FIGS. 15 through 17, an image IMG2 of each frame may be displayed by driving the second pixels PX2 in each frame period in response to the second emission mode (also referred to as a "second driving mode").

In the second emission mode, only a second pixel PX2 among a pair of a first pixel PX1 and the second pixel PX2 sharing a third subpixel SPX3 may be driven, and a gray level and color of data which corresponds to a corresponding unit area UNA among image data of one frame may be expressed by the second pixel PX2. For example, in the second emission mode, the first subpixel SPX1, the second subpixel SPX2, and the third subpixel SPX3 of the second pixel PX2 disposed in each unit area UNA may be driven during one frame period 1F, and accordingly, the gray level and color of each data may be expressed.

While the display device 10 is driven in the second emission mode, the first pixels PX1 may be turned off. For example, driving signals which may turn off the first pixels PX1 may be supplied to the first pixels PX1 in response to the second emission mode, thereby turning off the first pixels PX1. For example, in the second emission mode, the first subpixel SPX1 and the second subpixel SPX2 of the first pixel PX1 disposed in each unit area UNA may be turned off.

The second pixels PX2 may have a smaller light output angle and a smaller side luminance ratio than the first pixels PX1. The second emission mode for displaying an image using the second pixels PX2 may be a viewing angle limitation mode in which the viewing angle of an image displayed in the display area DA is limited, for example, may be a privacy mode or a security mode. For example, while the display device 10 is driven in the second emission mode, the side luminance ratio at a viewing angle of 45° may be reduced to less than or equal to about 20% (e.g., 10% or less). Accordingly, an image may be seen only by a user who looks at the display device 10 from the front and may not be properly seen by a user who looks at the display device 10 from a specific viewing angle or from the side. By driving the display device 10 in the second emission mode, it may be possible to appropriately limit the side visibility and viewing angle of the display device 10 and provide a privacy protection function or a security function according to the purpose of executing the second emission mode.

In the second emission mode, an image having a resolution corresponding to the number, arrangement structure, and/or density of the second pixels PX2 disposed in the display area DA may be displayed. For example, the display driver 200 may supply driving signals corresponding to the second emission mode to the second pixels PX2. For example, in response to the second emission mode, the display driver 200 may convert (or rearrange) image data received from the outside into image data corresponding to the resolution of the second pixels PX2 and supply data signals of each frame which correspond to the converted image data to the second pixels PX2 through the data lines. In response to the second emission mode, the display driver 200 may generate data signals by applying a second gamma value set according to emission characteristics of the second pixels PX2. For example, in the second emission mode in which an image is displayed by the second pixels PX2 whose first and second emission areas EA1 and EA2 are reduced in size (e.g., area) compared with those of the first pixels PX1, data signals may be generated by applying the second gamma value that can generate a higher driving current than in the first emission mode. This may compensate for a decrease in front luminance due to the decrease in light emitting area.

In case that a second light blocking layer BM2 surrounds only the first emission area EA1 and the second emission area EA2 of each of the second pixels PX2 and does not surround a third emission area EA3 of each of the second pixels PX2 as in the embodiment of FIG. 4 or 6, while the display device 10 is driven in the second emission mode, side light blocking rates of the first subpixel SPX1 and the second subpixel SPX2 may increase compared with the first emission mode, but a side light blocking rate of the third subpixel SPX3 may remain substantially the same. Accordingly, an image may be seen as bluish by a user who looks at the display device 10 from a specific viewing angle or from the side. However, even in this case, the side visibility and viewing angle of the display device 10 may be appropriately limited by the side light blocking effect of the first subpixel SPX1 and the second subpixel SPX2.

In case that the second light blocking layer BM2 surrounds the first emission area EA1, the second emission area EA2, and the third emission area EA3 of each of the second pixels PX2 located in second unit areas UNA2 as in the embodiment of FIG. 5 or 7, the side visibility and viewing angle of the display device 10 may be more effectively limited while the display device 10 is driven in the second emission mode, and the phenomenon that the side color of an image becomes bluish may be alleviated. Since the third emission area EA3 of each of the second pixels PX2 located in first unit areas UNA1 is not surrounded by the second light blocking layer BM2, it may be possible to prevent the side luminance ratio or visibility of an image from being significantly reduced in the first emission mode.

Referring to FIGS. 18 through 20, an image IMG3 of each frame may be displayed by sequentially or alternately driving the first pixels PX1 and the second pixels PX2 in response to the third emission mode (also referred to as a "third driving mode"). For example, in the third emission mode, a pair of a first pixel PX1 and a second pixel PX2 sharing a third subpixel SPX3 may be sequentially driven during each frame period or sub-frame period. Accordingly, a gray level and color of data which corresponds to a corresponding unit area UNA among image data of one frame or one sub-frame may be expressed by the first pixel PX1 and the second pixel PX2.

In an embodiment, the first pixels PX1 and the second pixels PX2 may be alternately driven in each frame period in response to the third emission mode. For example, in response to the third emission mode, one frame period 1F may be divided into a first sub-frame period SF1 (e.g., a first half frame) and a second sub-frame period SF2 (e.g., a second half frame), and the first pixels PX1 and the second pixels PX2 may be driven during the first sub-frame period SF1 and the second sub-frame period SF2, respectively. For example, during the first sub-frame period SF1, the first subpixel SPX1, the second subpixel SPX2, and the third subpixel SPX3 of the first pixel PX1 disposed in each unit area UNA may be driven, and the first subpixel SPX1 and the second subpixel SPX2 of the second pixel PX2 may be turned off. During the subsequent second sub-frame period SF2, the first subpixel SPX1 and the second subpixel SPX2 of the first pixel PX1 disposed in each unit area UNA may be turned off, and the first subpixel SPX1, the second subpixel SPX2, and the third subpixel SPX3 of the second pixel PX2 may be driven. Accordingly, a first half image IMG3_1 and a second half image IMG3_2 of one frame may be displayed by the first pixels PX1 and the second pixels PX2 during the first sub-frame period SF1 and the second sub-frame period SF2, respectively.

In an embodiment, in the third emission mode, the display device 10 may be driven at a higher frequency (e.g., twice higher) than in the first emission mode and the second emission mode. For example, the display device 10 may be driven at a frequency of 60 Hz in response to the first emission mode and the second emission mode and may be driven at a frequency of 120 Hz in response to the third emission mode.

In an embodiment, in response to the third emission mode, an image having a high resolution corresponding to the number, arrangement structure, and/or density of all pixels PX of the display area DA including the first pixels PX1 and the second pixels PX2 may be displayed. For example, the display driver 200 may supply driving signals, which correspond to a high-resolution image, to the first pixels PX1 and the second pixels PX2 in the third emission mode. For example, in response to the third emission mode, the display driver 200 may convert (or rearrange) image data received from the outside into image data of a high resolution corresponding to the resolution of the first pixels PX1 and the second pixels PX2 and supply data signals corresponding to the converted image data to the first pixels PX1 and the second pixels PX2. Gray levels and colors of the first half image IMG3_1 and the second half image IMG3_2 expressed by a pair of a first pixel PX1 and a second pixel PX2 in each unit area UNA during one frame period 1F may be independent of each other. For example, the gray level and color of the first half image IMG3_1 expressed in each unit area UNA and the gray level and color of the second half image IMG3_2 expressed in the unit area UNA may be same as or different from each other. However, embodiments are not limited thereto, and the first pixels PX1 and the second pixels PX2 may be driven based on a same frame data in the first sub-frame period SF1 and the second sub-frame period SF2, respectively.

In response to the third emission mode, the display driver 200 may generate data signals by applying each gamma value set according to the emission characteristics of the first pixels PX1 and the second pixels PX2. For example, the display driver 200 may generate first data signals for the first pixels PX1 during the first sub-frame period SF1 by applying the first gamma value and may generate second data signals for the second pixels PX2 during the second sub-frame period SF2 by applying the second gamma value.

In case that an image having a high resolution corresponding to the number, arrangement structure, and/or density of all pixels PX of the display area DA including the first pixels PX1 and the second pixels PX2 is displayed in response to the third emission mode, the third emission mode may be a high-resolution mode. In case that the first pixels PX1 and the second pixels PX2 are alternately driven at a high frequency in response to the third emission mode, the third emission mode may be a high-frequency mode.

In an embodiment, each emission mode (e.g., the first emission mode, the second emission mode, or the third emission mode) may be activated by a mode selection signal according to a user's selection. For example, in case that a mode selection signal indicating the selection of an emission mode is input, the display device 10 may be driven in the first emission mode, the second emission mode, or the third emission mode in response to the mode selection signal. In an embodiment, in case that a mode selection signal is not input by a user, the display device 10 may be driven in a designated emission mode (e.g., the first emission mode or the third emission mode) according to an initial setting value.

The number or type of emission modes utilizing the first pixels PX1 and the second pixels PX2 is not limited to the embodiments described above. For example, the number or type of emission modes that may be selected to adjust the luminance, viewing angle, and/or resolution of an image and/or the number or type of pixels PX driven in each emission mode may be variously changed according to embodiments. For example, the luminance, viewing angle, and/or resolution of an image may be adjusted in multiple emission modes according to various possible combinations in relation to the selective driving of the first pixels PX1 and the second pixels PX2.

In an embodiment, in case that the unit areas UNA of the display area DA include the first unit areas UNA1 and the second unit areas UNA2 having different structures in relation to the third subpixel SPX3 as in the embodiment of FIG. 5 or 7, the characteristics of an image displayed in the display area DA may be controlled by selectively and/or sequentially driving the pixels PX disposed in the first unit areas UNA1 and the second unit areas UNA2. For example, the resolution, color (e.g., side color), and visibility (e.g., side visibility) of an image displayed in the display area DA may be controlled by selectively driving the first pixels PX1 and/or the second pixels PX2 disposed in the first unit areas UNA1 and the second unit areas UNA2 according to each emission mode or driving purpose.

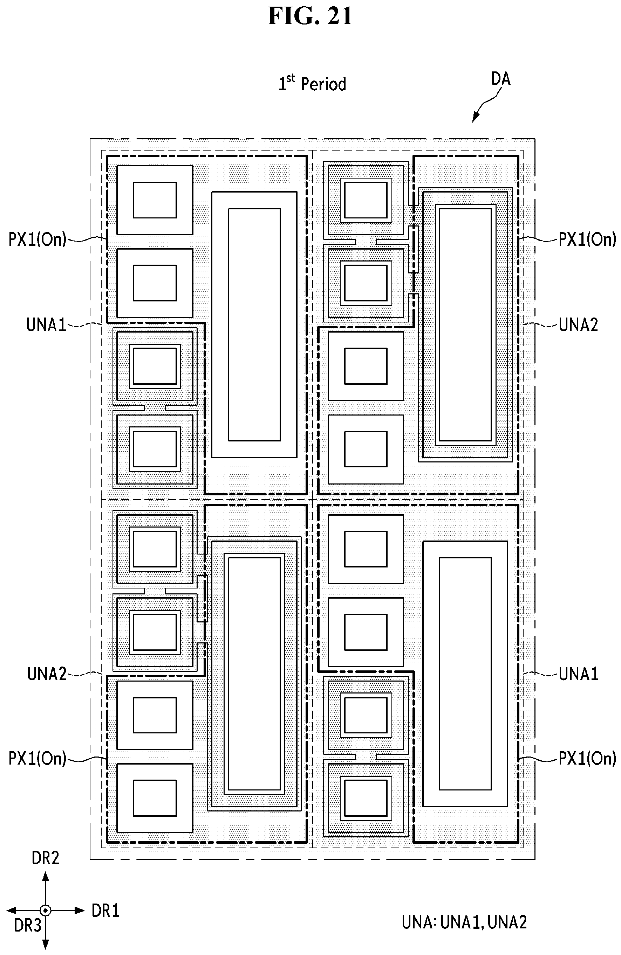

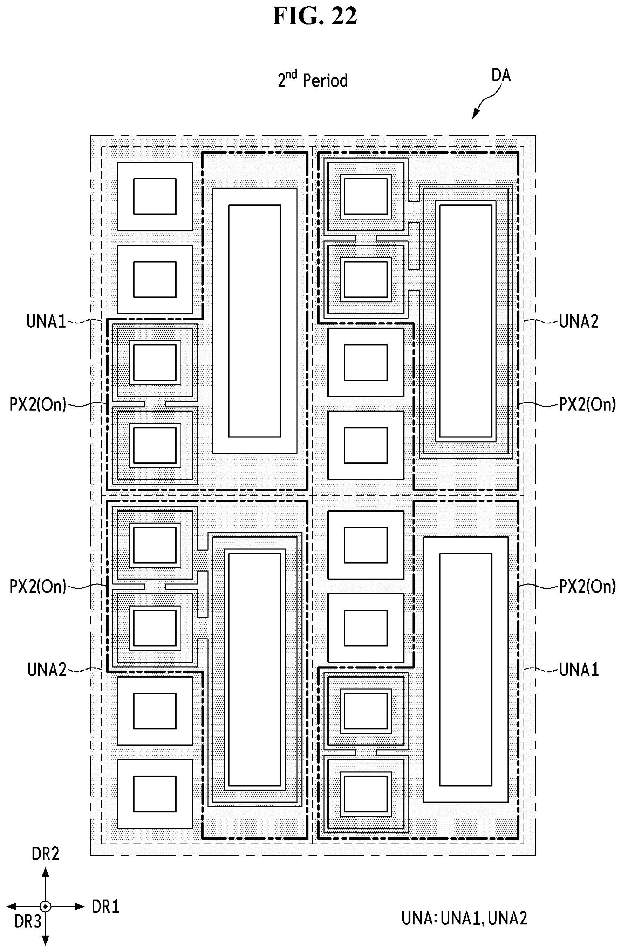

FIGS. 21 and 22 are schematic diagrams illustrating a method of driving a display device according to an embodiment. For example, FIGS. 21 and 22 schematically illustrate an embodiment of a method of driving the display device 10 according to the embodiment of FIG. 7.

Referring to FIGS. 21 and 22, first pixels PX1 and second pixels PX2 of a display area DA may be driven in different periods to display an image in response to an emission mode. For example, while the display device 10 is driven in an emission mode, the first pixels PX1 and the second pixels PX2 may be driven sequentially or alternately in each period including a first period and a second period.

In an embodiment, the first period 1^{st} Period and the second period 2^{nd} period may be periods corresponding to two successive frames or two successive sub-frames. For example, the first pixels PX1 and the second pixels PX2 disposed in unit areas UNA may be alternately driven in each frame period, or the first pixels PX1 and the second pixels PX2 disposed in the unit areas UNA may be alternately driven in each sub-frame period.

In an embodiment, the first pixels PX1 and the second pixels PX2 may be alternately driven in each frame period in response to a first emission mode. For example, the first pixels PX1 and the second pixels PX2 may be driven during the sequentially successive first and second frame periods to display an image of a first frame and an image of a second frame, respectively. Accordingly, the first pixels PX1 and the second pixels PX2 may be driven relatively uniformly in response to the first emission mode.

In an embodiment, the first pixels PX1 and the second pixels PX2 may be alternately driven in each sub-frame period in response to a third emission mode. For example, the first pixels PX1 and the second pixels PX2 may be respectively driven during a first sub-frame period and a second sub-frame period constituting one frame period to display an image of one frame.

In an embodiment, in case that a display driver 200 supplies data signals, which correspond to image data having a high resolution (e.g., 100%) corresponding to all pixels PX of the display area DA including the first pixels PX1 and the second pixels PX2, to the first pixels PX1 and the second pixels PX2, the display device 10 may display a high-resolution image. In an embodiment, the first pixels PX1 and the second pixels PX2 may be driven based on a same frame data in the first sub-frame period SF1 and the second sub-frame period SF2, respectively.

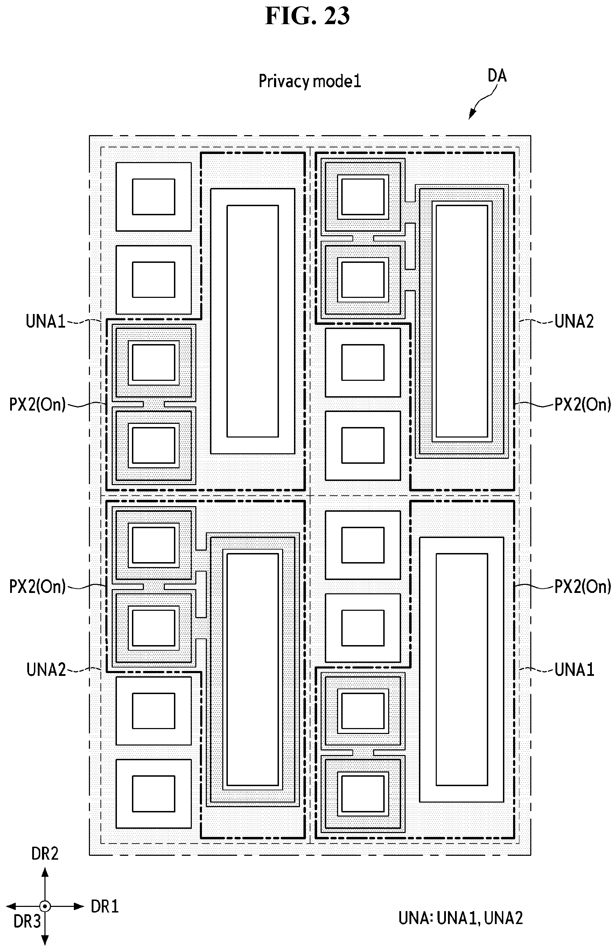

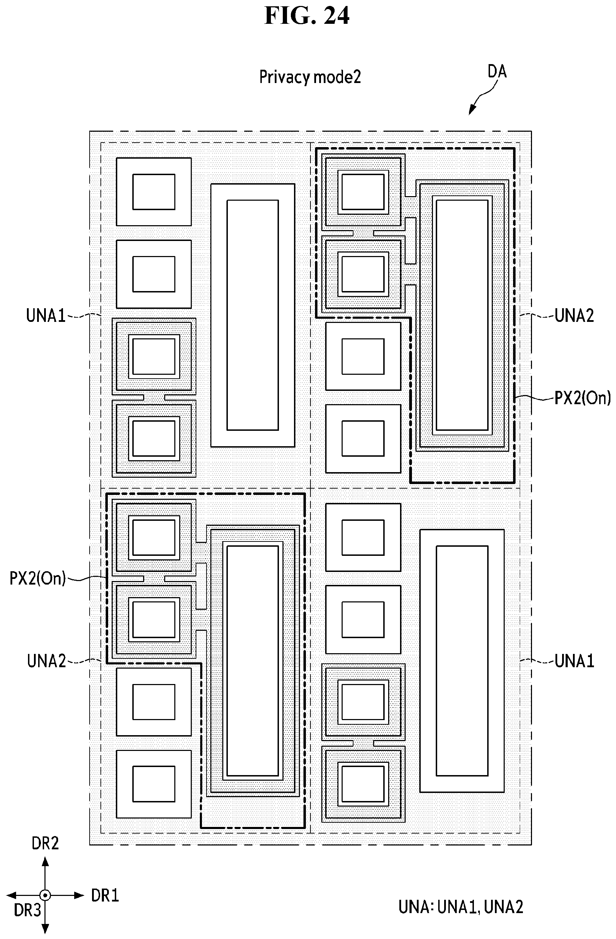

FIGS. 23 and 24 are schematic diagrams illustrating a method of driving a display device according to an embodiment. For example, FIGS. 23 and 24 schematically illustrate an embodiment of a method of driving the display device 10 according to the embodiment of FIG. 7.

Referring to FIGS. 23 and 24, in response to a specific emission mode, first pixels PX1 may be turned off, and all or only some of second pixels PX2 may be driven. In an embodiment, two options may be provided for a second emission mode. For example, in case that the display device 10 is driven in the second emission mode, one of a first privacy mode Privacy Mode1 and a second privacy mode Privacy Mode2 may be selected to limit the side visibility of the display device 10.

In an embodiment, in response to the first privacy mode, all of the second pixels PX2 disposed in first unit areas UNA1 and second unit areas UNA2 may be driven as illustrated in FIG. 23. Accordingly, an image may be displayed at a resolution of about 50% of the resolution for all pixels PX of the display area DA. Even in this case, since third emission areas EA3 disposed in the second unit areas UNA2 are surrounded by a second light blocking layer BM2, the phenomenon that the side color of an image becomes bluish may be alleviated.

In an embodiment, in response to the second privacy mode, the second pixels PX2 disposed in the first unit areas UNA1 may be turned off, and only the second pixels PX2 disposed in the second unit areas UNA2 may be driven as illustrated in FIG. 24. Accordingly, an image may be displayed at a resolution of about 25% of the resolution for all pixels PX of the display area DA. Since the third emission areas EA3 disposed in the second unit areas UNA2 are surrounded by the second light blocking layer BM2, the phenomenon that the side color of an image becomes bluish may be prevented.

In an embodiment, different gamma values may be applied in response to the first privacy mode and the second privacy mode in order to compensate for a difference in the luminance of an image due to a difference in the number of second pixels PX2 that are driven.

In the description of the embodiments of FIGS. 23 and 24, the first privacy mode and the second privacy mode are described as options that can be selected in the second emission mode, but embodiments are not limited thereto. For example, the first privacy mode and the second privacy mode may also be defined as emission modes. For example, the first privacy mode may be defined as the second emission mode, and the second privacy mode may be defined as a fourth emission mode. One of multiple emission modes including a first emission mode, the second emission mode, a third emission mode, and the fourth emission mode may be selected, and the display device 10 may be driven in a form corresponding to the selected emission mode.

The above description is an example of technical features of the invention, and those skilled in the art to which the invention pertains will be able to make various modifications and variations. Therefore, the embodiments of the invention described above may be implemented separately or in combination with each other.

The protection scope of the invention should be interpreted by the following claims.

## Claims

1. A display device (10) comprising:
a first pixel (PX1) and a second pixel (PX2) disposed in a first unit area (UNA1) among unit areas (UNA) of a display area (DA), each of the first pixel (PX1) and the second pixel (PX2) comprises a first subpixel (SPX1) and a second subpixel (SPX2), and the first pixel (PX1) and the second pixel (PX2) share a third subpixel (SPX3);
a first light blocking layer (BM1) disposed on a light emitting element layer (EML) which comprises light emitting elements (ED) of subpixels (SPX) disposed in each of the unit areas (UNA), the first light blocking layer (BM1) surrounds emission areas (EA) of the subpixels (SPX); and
a second light blocking layer (BM2) disposed on the first light blocking layer (BM1), the second light blocking layer (BM2) surrounds the emission areas (EA) of the first subpixel (SPX1) and the second subpixel (SPX2) of the second pixel (PX2) in the first unit area (UNA1),
wherein the first pixel (PX1) and the second pixel (PX2) are driven in different periods.

2. The display device (10) of claim 1, wherein
the first unit area (UNA1) comprises first emission areas (EA1) in which first light emitting elements (ED1) of the first subpixels (SPX1) are disposed, second emission areas (EA2) in which second light emitting elements (ED2) of the second subpixels (SPX2) are disposed, and a third emission area (EA3) in which a third light emitting element (ED3) of the third subpixel (SPX3) is disposed, and
a size of the third emission area (EA3) is greater than a size of each of the first emission areas (EA1) and the second emission areas (EA2).

3. The display device (10) of claim 2, wherein
the first light emitting elements (ED1) are red light emitting elements which emit red light,
the second light emitting elements (ED2) are green light emitting elements which emit green light, and
the third light emitting element (ED3) is a blue light emitting element which emits blue light.

4. The display device (10) of claim 2 or 3, wherein the first emission areas (EA1) and the second emission areas (EA2) are disposed adjacent to the third emission area (EA3) in a first direction (DR1).

5. The display device (10) of at least one of claims 2 to 4, wherein the third emission area (EA3) has short sides extending in the first direction (DR1) and long sides extending in a second direction (DR2).

6. The display device (10) of at least one of claims 1 to 5, wherein the first emission areas (EA1) and the second emission areas (EA2) are alternately arranged in the second direction (DR2).

7. The display device (10) of at least one of claims 1 to 6, further comprising:
a first pixel (PX1) and a second pixel (PX2) disposed in a second unit area (UNA2) among the unit areas (UNA), each of the first pixel (PX1) and the second pixel (PX2) in the second unit area (UNA2) comprises a first subpixel (SPX1) and a second subpixel (SPX2), and the first pixel (PX1) and the second pixel (PX2) in the second unit area (UNA2) share a third subpixel (SPX3),
wherein the second light blocking layer (BM2) in the first unit area (UNA1) and the second light blocking layer (BM2) in the second unit area (UNA2) have different shapes.

8. The display device (10) of claim 7, wherein the second light blocking layer (BM2) surrounds the emission areas (EA) of the first subpixel (SPX1) and the second subpixel (SPX2) of the second pixel (PX2) and the emission area (EA) of the third subpixel (SPX3) in the second unit area (UNA2) in a plan view.

9. The display device (10) of claim 7 or 8, wherein the second light blocking layer (BM2) surrounds only the emission areas (EA) of the first subpixel (SPX1) and the second subpixel (SPX2) of the second pixel (PX2) among the emission areas (EA) of the first unit area (UNA1) in a plan view.

10. The display device (10) of at least one of claims 7 to 9, wherein
the unit areas (UNA) comprise a plurality of first unit areas (UNA1) of a same structure and a plurality of second unit areas (UNA2) of a same structure, and
the plurality of first unit areas (UNA1) and the plurality of second unit areas (UNA2) are alternately arranged in a first direction (DR1).

11. The display device (10) of claim 10, wherein the plurality of first unit areas (UNA1) and the plurality of second unit areas (UNA2) are alternately arranged in a second direction (DR2) intersecting the first direction (DR1).

12. The display device (10) of at least one of claims 7 to 11, wherein
the first subpixel (SPX1) and the second subpixel (SPX2) of the first pixel (PX1) and the first subpixel (SPX1) and the second subpixel (SPX2) of the second pixel (PX2) are sequentially disposed in the first unit area (UNA1) in one direction, and
the first subpixel (SPX1) and the second subpixel (SPX2) of the second pixel (PX2) and the first subpixel (SPX1) and the second subpixel (SPX2) of the first pixel (PX1) are sequentially disposed in the second unit area (UNA2) in the one direction.

13. The display device (10) of at least one of claims 1 to 12, wherein
the first light blocking layer (BM1) surrounds emission areas (EA) of all subpixels (SPX) disposed in each of the unit areas (UNA) and comprises openings which expose the light emitting elements (ED) of all the subpixels (SPX) in a plan view, and
the second light blocking layer (BM2) surrounds emission areas (EA) of some of the subpixels (SPX) disposed in each of the unit areas (UNA) and comprises openings which expose the light emitting elements (ED) of the some of the subpixels (SPX) in a plan view.

14. The display device (10) of at least one of claims 1 to 13, wherein first pixels (PX1) and second pixels (PX2) disposed in the unit areas (UNA) are driven in different ways in response to a first emission mode, a second emission mode, and a third emission mode.

15. The display device (10) of claim 14, wherein
the first pixels (PX1) are driven in each frame period (1F) in response to the first emission mode,
the second pixels (PX2) are driven in each frame period (1F) in response to the second emission mode, and
the first pixels (PX1) and the second pixels (PX2) are alternately driven in each frame period (1F) in response to the third emission mode.

16. The display device (10) of claim 14 or 15, further comprising:
a display driver (200) supplying data signals of each of the frame period (1F) to the first pixels (PX1) and the second pixels (PX2),
wherein the display driver (200) supplies data signals corresponding to a resolution of the first pixels (PX1) or the second pixels (PX2) to the first pixels (PX1) or the second pixels (PX2) in response to the first emission mode and the second emission mode and supplies data signals corresponding to a resolution of the first pixels (PX1) and the second pixels (PX2) to the first pixels (PX1) and the second pixels (PX2) in response to the third emission mode.

17. A method of driving a display device, in particular a display device (10) of at least one of claims 1 to 16, which comprises a first pixel (PX1) and a second pixel (PX2) disposed in each of unit areas (UNA) of a display area (DA) and sharing one subpixel, the method comprising:
displaying an image of each frame by driving the first pixels (PX1) disposed in the unit areas (UNA) in response to a first emission mode;
displaying an image of each frame by driving the second pixels (PX2) disposed in at least some of the unit areas (UNA) in response to a second emission mode; and
displaying an image of each frame by alternately driving the first pixels (PX1) and the second pixels (PX2) disposed in the unit areas (UNA) in response to a third emission mode.

18. The method of claim 17, wherein
data signals corresponding to a resolution of the first pixels (PX1) or the second pixels (PX2) are supplied to the first pixels (PX1) or the second pixels (PX2) in response to the first emission mode and the second emission mode, and
data signals corresponding to a resolution of the first pixels (PX1) and the second pixels (PX2) are supplied to the first pixels (PX1) and the second pixels (PX2) in response to the third emission mode.

19. The method of claim 17 or 18, wherein
in response to the third emission mode, one frame period (1F) is divided into a first sub-frame period (SF1) and a second sub-frame period (SF2),
the first pixels (PX1) are driven during the first sub-frame period (SF1), and
the second pixels (PX2) are driven during the second sub-frame period (SF2).

20. An electronic device comprising:
a display device, in particular a display device (10) of at least one of claims 1 to 16 comprising:
a first pixel (PX1) and a second pixel (PX2) disposed in a first unit area (UNA1) among unit areas (UNA) of a display area (DA), each of the first pixel (PX1) and the second pixel (PX2) comprises a first subpixel (SPX1) and a second subpixel (SPX2), and the first pixel (PX1) and the second pixel (PX2) share a third subpixel (SPX3);
a first light blocking layer (BM1) disposed on a light emitting element layer (EML) which comprises light emitting elements (ED) of subpixels (SPX) disposed in each of the unit areas (UNA), the first light blocking layer (BM1) surrounds emission areas (EA) of the subpixels (SPX); and
a second light blocking layer (BM2) disposed on the first light blocking layer (BM1), the second light blocking layer (BM2) surrounds the emission areas (EA) of the first subpixel (SPX1) and the second subpixel (SPX2) of the second pixel (PX2) in the first unit area (UNA1),
wherein the first pixel (PX1) and the second pixel (PX2) are driven in different periods.
